# EUROPEAN PATENT APPLICATION

(11) **EP 1 906 437 A1**
(43) Date of publication of application: **02.04.2008**
(21) Application number: 06767380.6
(22) Date of filing: 27.06.2006
(51) Int. Cl.: H01L 21/027, G03F 7/20

(54) **EXPOSURE METHOD, EXPOSURE DEVICE, AND DEVICE MANUFACTURING METHOD**

(30) Priority: 28.06.2005 JP 2005188837
(71) Applicant: NIKON CORPORATION, Tokyo 100-8831 (JP)
(72) Inventor: UEHARA, Yusaku c/o Nikon Corporation, Chiyoda-ku, Tokyo 1008331 (JP); UCHIKAWA, Kiyoshi c/o Nikon Corporation, Chiyoda-ku, Tokyo 1008331 (JP); ISHIYAMA, Satoshi c/o Nikon Corporation, Chiyoda-ku, Tokyo 1008331 (JP)
(74) Representative: HOFFMANN EITLE
(86) International application number: PCT/JP2006/312763
(87) International publication number: WO 2007/000984

(57) **Abstract**

By the combination of adjusting optical properties of an optical system (PLL) by an irradiation unit (91) irradiating non-exposure light on an optical element (90), which is movable, and adjusting the optical properties of the optical system (PLL) with an optical properties adjustment unit by moving the optical element (90), for example, the change in the optical properties of the optical system caused by the temperature distribution of the optical elements whose center is at a position eccentric from the optical axis is corrected. Further, under a dipole illumination condition, in order to make optical properties of an optical system caused by non-rotational symmetry temperature distribution of optical elements in the vicinity of pupils (PP1, PP2, PP3) into optical properties that can be corrected more easily by an optical properties adjustment unit, an irradiation unit (91A) irradiates non-exposure light on an optical element (111), which makes the optical element (111) have a rotational symmetry temperature distribution. Accordingly, optical properties change in the optical system due to illumination light absorption can be effectively corrected.

## Description

The present invention relates to exposure methods and exposure apparatus, and device manufacturing methods, and more particularly to an exposure method and an exposure apparatus that are used in a lithography process in which electronic devices such as a semiconductor device (an integrated circuit) or a liquid crystal display device are manufactured, and a device manufacturing method that uses the exposure method and the exposure apparatus.

Conventionally, in a lithography process for manufacturing electronic devices (microdevices) such as a semiconductor device (an integrated circuit or the like), a liquid crystal display device, or the like, a reduction projection exposure apparatus (the so-called stepper) by the step-and-repeat method that projects an image of a pattern of a mask (or a reticle) via a projection optical system onto each of a plurality of shot areas of a photosensitive object such as a wafer or a glass plate (hereinafter generally referred to as a 'wafer') on which a resist (a photosensitive material) is coated, or a projection exposure apparatus (the so-called scanning stepper) by the step-and-scan method is mainly used.

In these types of projection exposure apparatus, a higher resolving power (resolution) is required every year, due to finer patterns by higher integration of the integrated circuit, and recently, the exposure apparatus that utilizes the immersion method (hereinafter called `immersion exposure apparatus') is gaining attention.

In addition, in the immersion exposure apparatus, the opening of the projection optical system on the reticle side becomes larger with the substantial increase of the numerical aperture NA. Therefore, in a dioptric system consisting only of lenses, it becomes difficult to satisfy the Petzval condition, which tends to lead to an increase in the size of the projection optical system. Accordingly, to prevent such an increase in the size of the projection optical system, the arrangement of employing a catadioptric system as the projection optical system in an immersion exposure apparatus is being examined.

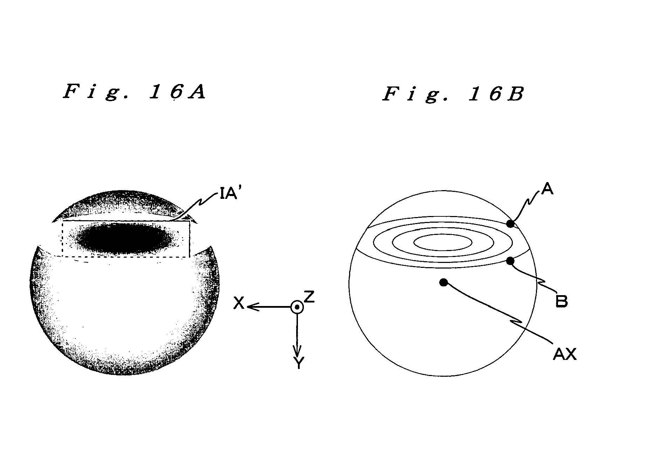

Yet, in the exposure apparatus that employs the catadioptric system as the projection optical system, in the lenses of the projection optical system in the vicinity of the object side and of the image plane, the optical path of the illumination light (illumination area IA') is set to an area eccentric from an optical axis as is shown in FIG. 16A. Therefore, in the lens, due to the illumination light absorption, a temperature distribution is generated as is shown by the contour line drawing in FIG. 16B, and because of the temperature distribution that is generated, aberration occurs in the projection optical system.

However, the aberration change due to the temperature distribution as is shown in the contour line drawing in FIG. 16B is difficult to correct by the image-forming characteristics correction mechanism typically employed in an exposure apparatus, such as the mechanism of vertically moving, or tilting the lenses that constitute a part of the projection optical system. For example, in the case of vertically moving the lenses, the aberration can be changed centering on an optical axis AX, however, it is difficult to correct the change in the aberration when it centers on a point eccentric from optical axis AX as is described above. In addition, at two points that are distanced differently from optical axis AX in FIG. 16B, such as in point A and point B, although the amount of aberration change generated by the temperature distribution is the same amount, because the amount of aberration change generated by tilting a lens changes according to the image height (the distance from the optical axis), the amount of aberration change generated by tilting the lens obviously differs between point A and point B.

It is assumed that a similar problem would occur in an optical system that irradiates illumination light centering on a point away from the optical axis, even if the system is not necessarily a catadioptric system.

According to a first aspect of the present invention, there is provided a first exposure method in which an object is exposed with a first energy beam via an optical system and a predetermined pattern is formed on the object, the method comprising: an irradiation process in which a second energy beam having a wavelength range different from the first energy beam is irradiated on at least one movable optical element constituting at least a part of the optical system so as to adjust optical properties of the optical system; and a correction process in which optical properties of the optical system is adjusted by moving at least one movable optical element including the one movable optical element on which the second energy beam is irradiated.

The order of the irradiation process and the correction process does not matter in particular, and the irradiation process and the correction process may be performed simultaneously in parallel.

With the method, by combining the processing in the irradiation process and the processing in the correction process, it becomes possible to correct the change in the optical properties of the optical system due to the temperature distribution of the optical elements with high precision, and as a consequence, by exposing the object with the first energy beam via the optical system whose change in the optical properties has been corrected, a predetermined pattern can be formed on the object with good precision.

According to a second aspect of the present invention, there is provided a second exposure method in which an object is exposed with an energy beam via an optical system and a predetermined pattern is formed on the object, the method using a catadioptric system in which the energy beam passes through an area eccentric to the optical axis at a plurality of points including an end section on the object side and an end section on the opposite side as the optical system, the system containing at least one dioptric element and at least one catoptric element, wherein the method comprises an adjustment process in which in a plurality of optical elements of the optical system, optical properties of the optical system is adjusted by performing at least temperature adjustment of a predetermined optical element in which the energy beam passes at a position eccentric to the optical axis so as to make the predetermined optical element have a concentric temperature distribution around the optical axis.

With this method, the optical properties of the optical system is adjusted by adjusting the temperature of the predetermined optical element among the plurality of optical elements in the optical system, which is a catadioptric system, so that the predetermined optical element in which the energy beam passes at a position eccentric to the optical axis will have a concentric temperature distribution around the optical axis. In this case, the change in the optical properties of the optical system corresponding to the concentric temperature distribution of the optical element around the optical axis after the adjustment of the optical properties can be easily corrected, and as a consequence, by exposing the object with the energy beam via the optical system whose change in the optical properties has been corrected, a predetermined pattern can be formed on the object with good precision.

According to a third aspect of the present invention, there is provided a third exposure method in which an object is exposed with an energy beam via an optical system and a predetermined pattern is formed on the object, the method using a catadioptric system in which the energy beam passes through an area eccentric to the optical axis at a plurality of points including an end section on the object side and an end section on the opposite side as the optical system, the system containing at least one dioptric element and at least one catoptric element, wherein the method comprises an adjustment process in which in a plurality of optical elements of the optical system, optical properties of the optical system is adjusted by performing at least temperature adjustment of a predetermined optical element in which the energy beam passes at a position eccentric to the optical axis so as to make the predetermined optical element have a temperature distribution that gradually changes from one side to the other side within a plane orthogonal to the optical axis.

With this method, the optical properties of the optical system is adjusted by adjusting the temperature of the predetermined optical element among the plurality of optical elements in the optical system, which is a catadioptric system, so that the predetermined optical element in which the energy beam passes at a position eccentric to the optical axis will have a temperature distribution that gradually changes from one side to the other side in the plane orthogonal to the optical axis. In this case, the change in the optical properties of the optical system corresponding to the temperature distribution that gradually changes from one side to the other side in the plane orthogonal to the optical axis of the optical element after the adjustment of the optical properties can be easily corrected, and as a consequence, by exposing the object with the energy beam via the optical system whose change in the optical properties has been corrected, a predetermined pattern can be formed on the object with good precision.

According to a fourth aspect of the present invention, there is provided a fourth exposure method in which an object is exposed with a first energy beam via an optical system and a predetermined pattern is formed on the object, the method using a catadioptric system which contains at least one dioptric element and at least one catoptric element as the optical system, wherein the method comprises an irradiation process in which a second energy beam having a wavelength range different from the first energy beam is irradiated on a dioptric element configuring a part of the optical system where the first energy beam passes back and forth, so as to adjust optical properties of the optical system.

With this method, since the second energy beam having a wavelength range different from the first energy beam is irradiated on the dioptric element configuring a part of the optical system where the first energy beam passes back and forth, or in other words, on the dioptric element whose energy absorption of the first energy beam that has been irradiated is larger than the optical element in which the first energy beam passes only once, it becomes possible to effectively correct the change in the optical properties of the optical system due to the irradiation of the first energy beam. Further, by exposing the object with the first energy beam via the optical system whose change in the optical properties has been corrected, a predetermined pattern can be formed on the object with good precision.

According to a fifth aspect of the present invention, there is provided a fifth exposure method in which an object is exposed with a first energy beam via an optical system and a predetermined pattern is formed on the object, the method using a catadioptric system which contains at least one dioptric element and at least one catoptric element and has a plurality of pupils that are optically conjugate as the optical system, wherein the method comprises an irradiation process in which a second energy beam having a wavelength range different from the first energy beam is irradiated on an optical element located in the vicinity of a pupil besides the pupil closest to the object of the plurality of pupils, so as to adjust the optical properties of the optical system.

In general, when the numerical aperture (NA) of the optical system becomes large, of the plurality of optical elements in the optical system, the optical elements close to the object tend to be large. In the present invention, however, in order to adjust the optical properties of the optical system, because the second energy beam having a wavelength range different from the first energy beam is irradiated on an optical element located in the vicinity of a pupil besides the pupil closest to the object among the plurality of pupils, it becomes possible to irradiate the second energy beam onto a relatively small optical element, which allows an effective radiation of the second energy beam. Further, by exposing the object with the first energy beam via the optical system whose change in the optical properties has been corrected, a predetermined pattern can be formed on the object with good precision.

According to a sixth aspect of the present invention, there is provided a first exposure apparatus that exposes an object with a first energy beam and forms a predetermined pattern on the object, the apparatus comprising: an optical system that comprises at least one movable optical element and emits the first energy beam on the object; an irradiation unit that irradiates a second energy beam having a wavelength range different from the first energy beam on the at least one movable optical element so as to adjust the optical properties of the optical system; and an optical properties adjustment unit that adjusts the optical properties of the optical system by moving at least one movable optical element including the movable optical element on which the second energy beam is irradiated.

With this apparatus, by combining the optical properties adjustment of the optical system by irradiating the second energy beam on at least one movable optical element with the irradiation unit and the optical properties adjustment of the optical system by moving at least one movable optical element with the optical properties adjustment unit, it becomes possible to correct the change in the optical properties of the optical system that occurs due to the temperature distribution of the optical elements with high precision.

In this case, either the irradiation unit or the optical properties adjustment unit can perform the optical properties adjustment of the optical system first, or the optical properties adjustment of the optical system can be performed simultaneously in parallel.

According to a seventh aspect of the present invention, there is provided a second exposure apparatus that exposes an object with an energy beam and forms a predetermined pattern on the object, the apparatus comprising: an optical system composed of a catadioptric system in which the energy beam passes through an area eccentric to the optical axis at a plurality of points including an end section on the object side and an end section on the opposite side, the system containing at least one dioptric element and at least one catoptric element; and an optical properties adjustment unit that adjusts the optical properties of the optical system by performing at least temperature adjustment of a predetermined optical element in which the energy beam passes at a position eccentric to the optical axis among a plurality of optical elements in the optical system so as to make the predetermined optical element have a concentric temperature distribution around the optical axis.

With this apparatus, the optical properties of the optical system is adjusted by the optical properties adjustment unit, which performs temperature adjustment of a predetermined optical element in which the energy beam passes at a position eccentric to the optical axis among the plurality of optical elements in the optical system composed of a catadioptric system, so as to make the predetermined optical element have a concentric temperature distribution around the optical axis. In this case, the change in the optical properties of the optical system corresponding to the concentric temperature distribution around the optical axis in the optical element described above whose optical properties have been adjusted can be easily corrected.

According to an eighth aspect of the present invention, there is provided a third exposure apparatus that exposes an object with an energy beam and forms a predetermined pattern on the object, the apparatus comprising: an optical system composed of a catadioptric system in which the energy beam passes through an area eccentric to the optical axis at a plurality of points including an end section on the object side and an end section on the opposite side , the system containing at least one dioptric element and at least one catoptric element; and an optical properties adjustment unit that adjusts optical properties of the optical system by performing at least temperature adjustment of a predetermined optical element in which the energy beam passes at a position eccentric to the optical axis among a plurality of optical elements in the optical system so as to make the predetermined optical element have a temperature distribution that gradually changes from one side to the other side within a plane orthogonal to the optical axis.

With this apparatus, the optical properties of the optical system is adjusted by the optical properties adjustment unit, which performs temperature adjustment of a predetermined optical element in which the energy beam passes at a position eccentric to the optical axis among the plurality of optical elements in the optical system composed of a catadioptric system, so as to make the predetermined optical element have a temperature distribution that gradually changes from one side to the other side within the plane orthogonal to the optical axis. In this case, the change in the optical properties of the optical system corresponding to the temperature distribution that gradually changes from one side to the other side in the plane orthogonal to the optical axis in the optical element described above whose optical properties have been adjusted can be easily corrected.

According to a ninth aspect of the present invention, there is provided a fourth exposure apparatus that exposes an object with a first energy beam and forms a predetermined pattern on the object, the apparatus comprising: an optical system composed of a catadioptric system that emits the first energy beam on the object, the system containing at least one dioptric element and at least one catoptric element; and an irradiation unit that irradiates a second energy beam having a wavelength range different from the first energy beam on a dioptric element configuring a part of the optical system where the first energy beam passes back and forth, so as to adjust optical properties of the optical system.

According to the apparatus, since the irradiation unit can irradiate the second energy beam having a wavelength range different from the first energy beam on the dioptric element configuring a part of the optical system where the first energy beam passes back and forth, or in other words, on the dioptric element whose energy absorption of the first energy beam that has been irradiated is larger than the optical element in which the first energy beam passes only once, it becomes possible to effectively correct the change in the optical properties of the optical system due to the irradiation of the first energy beam.

According to a tenth aspect of the present invention, there is provided a fifth exposure apparatus that exposes an object with a first energy beam and forms a predetermined pattern on the object, the apparatus comprising: an optical system that emits the first energy beam on the object, the system containing at least one dioptric element and at least one catoptric element and has a plurality of pupils that are optically conjugate; and an irradiation unit that irradiates a second energy beam having a wavelength range different from the first energy beam on an optical element, located in the vicinity of a pupil besides the pupil closest to the object of the plurality of pupils, so as to adjust the optical properties of the optical system.

In general, when the numerical aperture (NA) of the optical system becomes large, of the plurality of optical elements in the optical system, the optical elements close to the object tend to be large. In the present invention, however, in order to adjust the optical properties of the optical system, because the irradiation unit irradiates the second energy beam having a wavelength range different from the first energy beam on an optical element located in the vicinity of a pupil besides the pupil closest to the object among the plurality of pupils, it becomes possible to irradiate the second energy beam onto a relatively small optical element, which allows an effective radiation of the second energy beam.

Further, in a lithography process, by using any one of the exposure methods in the first to fifth exposure methods of the present invention to form a device pattern on an object, the device pattern can be formed on the object with good precision. Accordingly, it can also be said from another aspect that the present invention is a device manufacturing method including a lithography process that uses any one of the exposure methods in the first to fifth exposure methods of the present invention to form a device pattern on an object. Similarly, in a lithography process, by using any one of the exposure apparatus in the first to fifth exposure apparatus of the present invention to form a device pattern on an object, the device pattern can be formed on the object with good precision. Accordingly, it can also be said from another aspect that the present invention is a device manufacturing method including a lithography process that uses any one of the exposure apparatus in the first to fifth exposure apparatus of the present invention to form a device pattern on an object.
FIG. 1 is a view that schematically shows a configuration of an exposure apparatus in an embodiment of the present invention.
FIG. 2 is a view that shows a projection optical system along with a non-exposure light irradiation mechanism.
FIG. 3 is an example of a detailed arrangement of a non-exposure light irradiation mechanism 91.
FIG. 4 is a sectional view of an optical unit PU along line B-B in FIG. 2, which is a view for describing an example of the irradiation mechanism that irradiates non-exposure light on a lens 111 in the vicinity of a pupil.
FIG. 5 is a sectional view that shows the vicinity of the image plane side of the projection optical system and a nozzle member.
FIG. 6 is a view that shows the nozzle member when viewed from below.
FIG. 7 is a block diagram of the main section of a control system of the apparatus in FIG. 1.
FIG. 8A is a view that shows the irradiation of non-exposure light so as to generate a rotational symmetry temperature distribution a lens 90 of the projection optical system, whereas FIG. 8B is a view that shows the rotational symmetry aberration generated in the projection optical system by the irradiation of the non-exposure light.
FIG. 9A is a view that shows the irradiation of non-exposure light so as to generate a temperature distribution that gradually changes from one side to the other side within a plane perpendicular to the optical axis in lens 90 of the projection optical system, whereas FIG. 9B is a view that shows the aberration that gradually changes from one side to the other side generated in the projection optical system by the irradiation of the non-exposure light.
FIG. 10 is a view that shows a light quantity distribution of the illumination light on the lens in the vicinity of a pupil plane of the projection optical system under an X-axis dipole illumination condition.
FIG. 11 is a view that shows a light quantity distribution of the illumination light on the lens in the vicinity of a pupil plane of the projection optical system under a Y-axis dipole illumination condition.
FIG. 12 is a view that shows a temperature distribution that occurs in the lens in the vicinity of a pupil plane of the projection optical system under an X-axis dipole illumination condition.
FIG. 13 is a view that shows a temperature distribution that occurs in the lens in the vicinity of a pupil plane of the projection optical system under a Y-axis dipole illumination condition.
FIG. 14 is flow chart used to explain an embodiment of a device manufacturing method according to the present invention.
FIG. 15 is flow chart that shows a concrete example related to step 204 in FIG. 14.
FIGS. 16A and 16B are views used to explain the background art.

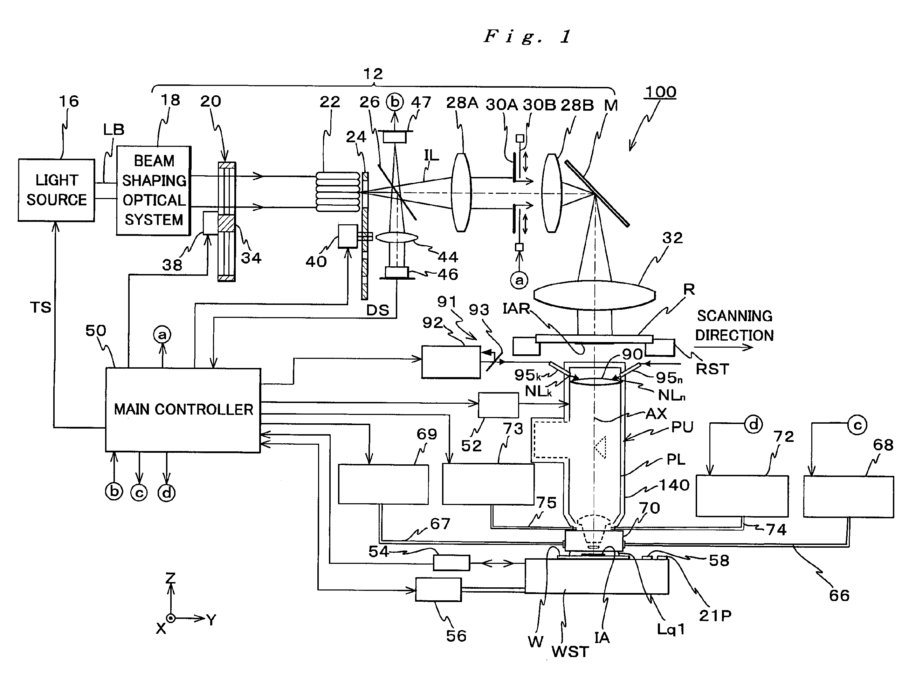

An embodiment of the present invention is described below, referring to FIGS. 1 to 13.

FIG. 1 schematically shows an arrangement of an exposure apparatus 100 related to an embodiment. Exposure apparatus 100 is a scanning exposure apparatus by the step-and-scan method, that is, the so-called scanner.

Exposure apparatus 100 is equipped with the following: an illumination system that includes a light source 16 and an illumination optical system 12; a reticle stage RST that holds a reticle R, which is illuminated by an exposure illumination light IL emitted from the illumination system, and moves in a predetermined scanning direction (in this case, a Y-axis direction, which is the lateral direction within the page surface of FIG. 1); a projection unit PU that includes a projection optical system PL, which projects the pattern of reticle R on a wafer W serving as an object; and a wafer stage WST that holds wafer W and moves on a horizontal surface (within an XY plane), and an immersion mechanism, a control system that controls the parts above, and the like.

As light source 16, as an example, an ArF excimer laser (output wavelength: 193 nm), which is a pulsed light source that emits light in the vacuum ultraviolet region with the wavelength of 200 nm to 170 nm, is used.

Illumination optical system 12 includes parts disposed in a predetermined positional relation, such as a beam shaping optical system 18, a rough energy adjuster 20, an optical integrator (a uniformizer, or a homogenizer) 22, an illumination system aperture stop plate 24, a beam splitter 26, a first relay lens 28A, a second relay lens 28B, a first reticle blind 30A, a second reticle blind 30B, a mirror M for bending the optical path, a condenser lens 32, and the like. As optical integrator 22, a fly-eye lens is used in FIG. 1. Therefore, in the following description, optical integrator 22 will also be referred to as a `fly-eye lens.' Further, as optical integrator 22, an internal reflection type integrator (such as a rod integrator) or a diffraction optical element can also be used.

Rough energy adjuster 20 is disposed on the optical path of a laser beam LB, behind beam shaping optical system 18, which shapes the cross-sectional shape of laser beam LB entering from light source 16. Rough energy adjuster 20 has a revolving plate (revolver) 34 in which a plurality of (e.g., six) attenuation filters (hereinafter also referred to as ND filters, and in FIG. 1, only two ND filters are shown) with a different transmittance (=1-attenuation ratio) is disposed along a circumferential direction at a predetermined distance, and by rotating revolving plate 34 with a drive motor 38, the transmissivity to laser beam LB that enters can be switched from 100% in a plurality of steps. Drive motor 38 operates under the control of a main controller 50. Rough energy adjuster 20 may be an adjuster that continuously varies the transmittance of laser beam LB.

On the optical path of laser beam LB behind rough energy adjuster 20, illumination system aperture stop plate 24 consisting of a disc-shaped member is disposed via fly-eye lens 22. In this case, illumination system aperture stop plate 24 is disposed on the focal plane on the exit side of fly-eye lens 22, or in the embodiment, is disposed substantially coinciding with the pupil plane of illumination optical system 12. On illumination system aperture stop plate 24 at a substantially equal angle, a plurality of types of aperture stops (only two types of aperture stops are shown in FIG. 1) is disposed. The plurality of types of aperture stops include an aperture stop (conventional stop) constituted by a typical circular opening, an aperture stop (a small σ stop) constituted by a small, circular opening for making coherence factor σ smaller than the conventional stop, a ring-shaped aperture stop (annular stop) for annular illumination, and a plurality of types of modified aperture stops (for example, a two-pole stop for setting an X-axis dipole illumination condition, a two-pole stop for setting a Y-axis dipole illumination condition, and the like) composed of a plurality of openings disposed in an eccentric arrangement for a modified light source method (multipolar illumination). Illumination system aperture stop plate 24 is made to be rotated by a driving unit 40 such as a motor operating under the control of main controller 50, and with this operation, one of the aperture stops is selectively set on the optical path of illumination light IL, and a secondary light source of various shapes and sizes is formed on the arrangement surface of illumination system aperture stop plate 24, or in other words, on the pupil plane of illumination optical system 12. In the embodiment, the intensity distribution of illumination light IL (that is, the illumination conditions of reticle R) on the pupil plane of illumination optical system 12 can be changed by aperture stop plate 24. The present invention, however, is not limited to this, and instead of aperture stop plate 24, for example, any one of a diffractive optical element that can be switched, a plurality of prisms (such as an axicon) whose distance in the optical axis direction is variable, and a shaping optical system that includes a zoom optical system can also be used.

On the optical path of laser beam LB emitted from the secondary light source behind illumination system aperture stop plate 24, that is, on the optical path of illumination light IL, beam splitter 26 is disposed that has low reflectivity and high transmittance, and further downstream from beam splitter 26 on the optical path, a relay optical system that includes the first relay lens 28A and the second relay lens 28B is disposed, with the first reticle blind (a fixed field stop) 30A and the second reticle blind (a movable field stop) 30B disposed in between.

The first reticle blind 30A is disposed on a plane slightly defocused from the plane conjugate to the pattern surface of reticle R, and sets an illumination area IAR on reticle R. In addition, the second reticle blind 30B is disposed in the vicinity of the arrangement surface of the first reticle blind 30A, and at the beginning and the end of scanning exposure, by limiting illumination area IAR further using the second reticle blind 30B, exposure of unnecessary areas of wafer W can be prevented.

On the optical path of illumination light IL behind the second relay lens 28B, a bending mirror M is disposed for reflecting illumination light IL having passed through the second relay lens 28B toward reticle R. And, on the optical path of illumination light IL behind mirror M, condenser lens 32 is disposed.

Meanwhile, illumination light IL emitted from one of the aperture stops of illumination system aperture stop plate 24 and reflected off one of the surfaces (the front surface) of beam splitter 26 is received by an integrator sensor 46 consisting of a photoelectric conversion element, via a condenser lens 44. Photoelectric conversion signals of integrator sensor 46 are sent to main controller 50 as output DS (digit/pulse) via a hold circuit and an A/D converter (not shown), or the like. As integrator sensor 46, a PIN type photodiode or the like that is sensitive, for example, in the vacuum ultraviolet region, and also has high response frequency for detecting the pulsed light from light source 16 can be used.

In addition, in order to receive the light reflected off the other plane (the back surface) of beam splitter 26, a reflection amount monitor 47, which consists of a photoelectric conversion element, is disposed at a position conjugate with the pupil plane of illumination optical system 12. In the embodiment, illumination light IL reflected off wafer W (reflection light) returns to beam splitter 26, via projection optical system PL, condenser lens 32, mirror M, and the relay optical system. Then, the light reflected off beam splitter 26 is received by reflection amount monitor 47, and the detection signals of reflection amount monitor 47 is to be supplied to main controller 50. Reflection amount monitor 47 is used for measuring the wafer reflectivity, which is the base for calculating the change in image-forming characteristics (various aberrations) caused by illumination light absorption by the optical system, or the so-called irradiation variation.

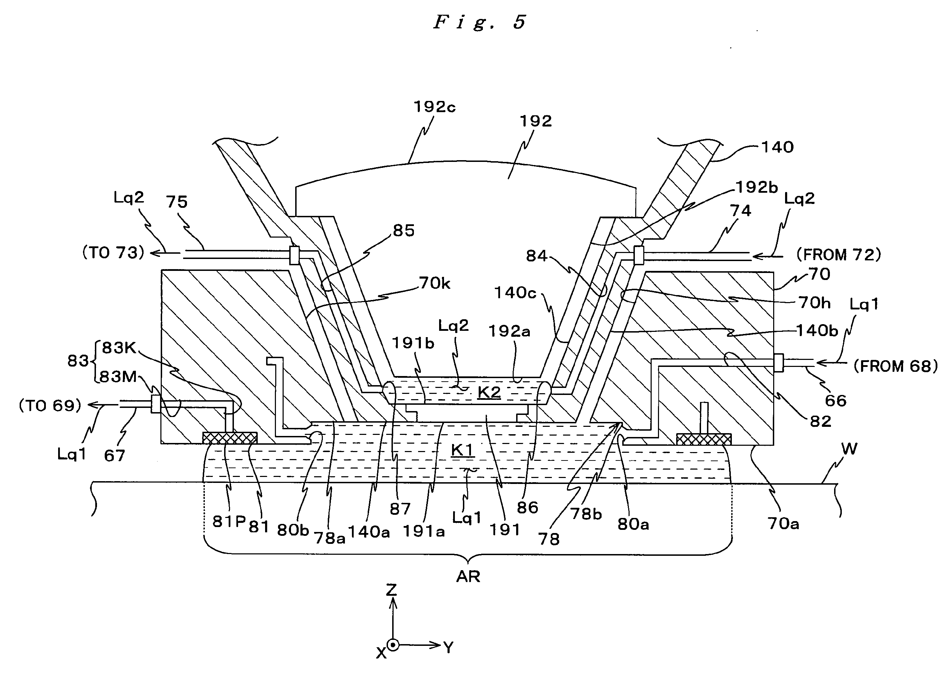

Accordingly, light quantity (a first light quantity) of illumination light IL, which passes through projection optical system PL and a liquid Lq1 filled in the space between projection optical system PL and wafer W via reticle R, is monitored by the output signals of integrator sensor 46, whereas light quantity (a second light quantity) of the reflection light, which is reflected off wafer W and passes through liquid Lq1 and projection optical system PL again, can be monitored by the detection signals of reflection amount monitor 47. Therefore, based on the first light quantity and the second light quantity, the total light quantity of light that passes through projection optical system PL and liquid Lq1 can be monitored more precisely. As it will be described later in the description, in the embodiment, a liquid Lq2 (refer to FIG. 5) is to be filled in the space between an optical element that constitutes projection optical system PL closest to the image plane and an optical element adjacent to the optical element closest to the image plane, however, in the description above, liquid Lq2 is viewed as a part of an optical element that constitutes projection optical system PL, therefore, in this case, only liquid Lq1 is described separately from projection optical system PL.

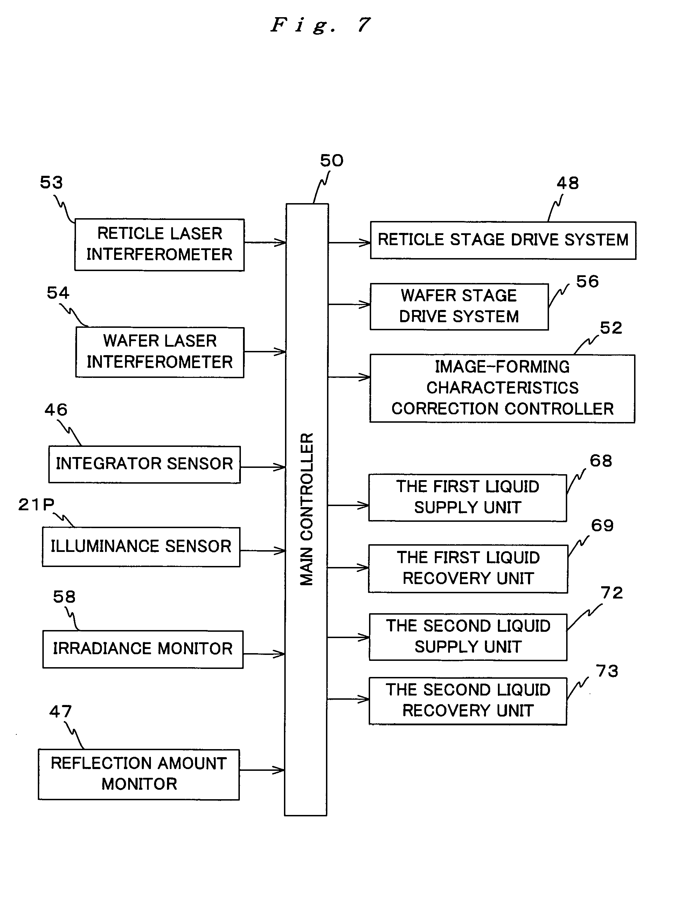

On reticle stage RST, reticle R is mounted, and held by suction, by a vacuum chuck or the like (not shown). Reticle stage RST can be finely driven within a horizontal plane (an XY plane), for example, by a reticle stage drive system 48 (not shown in FIG. 1, refer to FIG. 7) of a linear motor method. Reticle stage RST is also scanned in the scanning direction (in this case, the Y-axis direction, which is the lateral direction of the page surface of FIG. 1) within a predetermined stroke range. The position of reticle stage RST is measured using a side surface (reflection surface) of reticle stage RST that has been mirror-polished, by a reticle laser interferometer 53 (not shown in FIG. 1, refer to FIG. 7) externally arranged, and the measurement values of reticle laser interferometer 53 are supplied to main controller 50.

In the embodiment, as is shown in FIG. 1, projection unit PU is disposed below reticle stage RST. Projection unit PU includes a barrel 140, and projection optical system PL that has a plurality of optical elements that are held in a predetermined positional relation inside barrel 140. In addition, in the embodiment, a catadioptric system is used as projection optical system PL.

In exposure apparatus 100 of the embodiment, since exposure is performed applying the immersion method as is described later in the description, the opening on the reticle side becomes larger with the substantial increase of the numerical aperture NA. Therefore, in a dioptric system consisting only of lenses, it becomes difficult to satisfy the Petzval condition, which tends to lead to an increase in the size of the projection optical system. The catadioptric system was employed as projection optical system PL, in order to prevent such an increase in the size of the projection optical system.

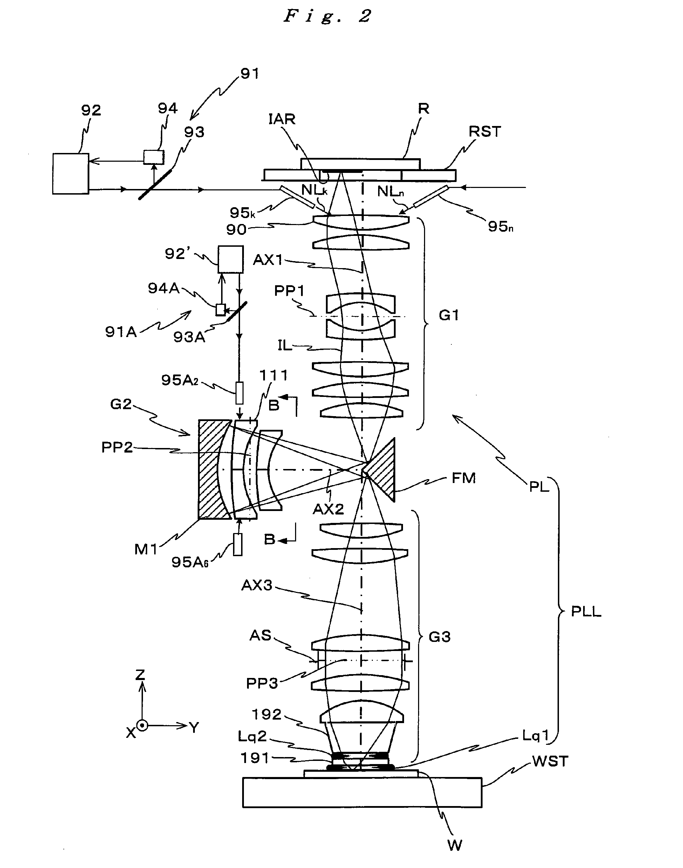

FIG. 2 shows an example of an arrangement of projection optical system PL, along with reticle R (reticle stage RST) and wafer W (wafer stage WST) . Projection optical system PL includes three image-forming optical systems G1, G2, G3, and the like disposed at a predetermined positional relation within barrel 140, and as a whole, the system is a reduction optical system (the projection magnification is, for example, 1/4, 1/5, or 1/8). As the material of each lens of projection optical system PL in the embodiment, quartz and/or fluorite is used, since the light source is an ArF excimer laser.

Projection optical system PL is equipped with a first image-forming optical system G1 of a refraction type that forms a primary image of the pattern formed on reticle R, a second image-forming optical system G2 of a catadioptric type that forms a secondary image by re-imaging the primary image, and a third image-forming optical system G3 that forms a final image by re-imaging the secondary image on the wafer. As is shown in FIG. 2, projection optical system PL has a first pupil PP1 inside the first image-forming optical system G1, a second pupil PP2 in the vicinity of a lens 111 that constitutes a part of the second image-forming optical system G2, and a third pupil PP3 inside the third image-forming optical system G3. The first pupil PP1, the second pupil PP2, and the third pupil PP3 are optically conjugate, and the pupils PP1 to PP3 also optically conjugate with the pupil of illumination optical system 12. Accordingly, at the position of the first pupil PP1, the second pupil PP2, and the third pupil PP3, the image of the secondary light source formed on the pupil plane of illumination optical system 12 is formed. At the position of the third pupil PP3, an aperture stop AS that sets the numerical aperture (NA) of projection optical system PL is arranged.

On the optical path between the first image-forming optical system G1 and the second image-forming optical system G2 and the optical path between the second image-forming optical system G2 and the third image-forming optical system G3, an optical path bending mirror FM is disposed. An optical axis AX1 of the first image-forming optical system G1 and an optical axis AX3 of the third image-forming optical system G3 share an axis, and the optical axes AX1 and AX3 and an optical axis AX2 of the second image-forming optical system G2 intersect at one point. And, a virtual vertex (ridge line) of two reflection surfaces of optical path bending mirror FM is positioned at this intersecting point.

In projection optical system PL, because a concave reflection mirror M1 that constitutes a part of the second image-forming optical system G2 contributes to the Petzval sum in the same manner as a negative lens while having a positive refracting power, the Petzval sum can be corrected easily by the combination of concave reflection mirror M1 and a positive lens, which allows curvature of image plane to be favorably corrected. Accordingly, spherical aberration and coma can be favorably corrected in the entire effective imaging area (effective exposure area) even when numerical aperture NA on the image side is large. And, one or more negative lens is disposed inside the second image-forming optical system G2, and in cooperation of such negative lenses and concave reflection mirror M1, chromatic aberration that occurs in the first image-forming optical system G1 and the third image-forming optical system G3 is compensated.

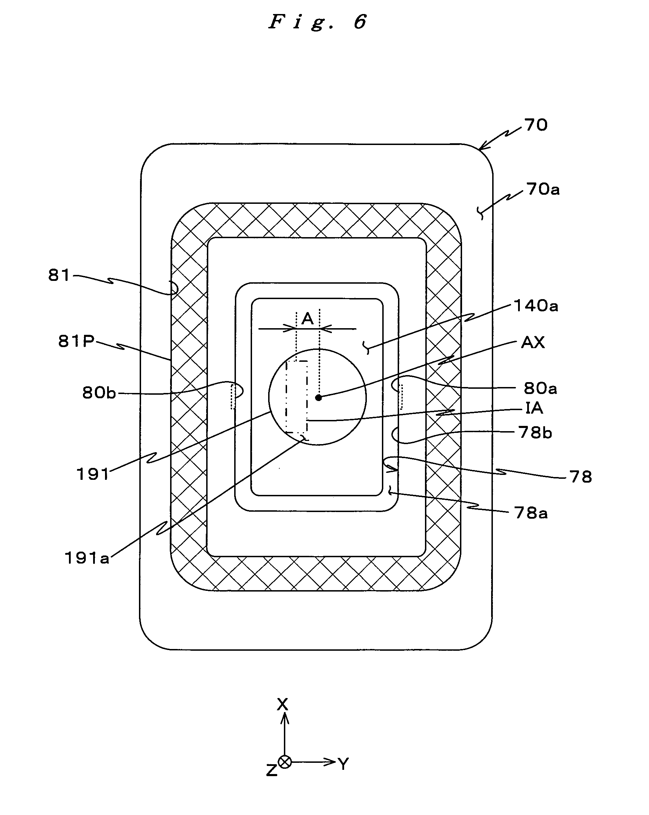

In the case of using a catadioptric system such as projection optical system PL, the problem of how to separate the light that proceeds toward concave reflection mirror M1 and the returning light that is reflected off concave reflection mirror M1 occurs. Projection optical system PL of the embodiment has an effective exposure area (effective imaging area) IA that is decentered by a distance A on the -Y side of optical axis AX (that is, optical axes AX1 and AX3) as is shown in FIG. 6, and forms two intermediate images (the primary image and the secondary image described above) on the optical path. Then, in the vicinity of the two intermediate images, a flat reflection mirror for separating the optical path, or in other words, the two reflection surfaces of optical path bending mirror FM, is disposed, so as to easily separate the light proceeding toward concave reflection mirror M1 and the returning light reflected off concave reflection mirror M1. This configuration allows distance A of exposure area (that is, effective exposure area) IA from optical axis AX, that is, the axis decentered amount, to be set small. This is advantageous not only from the point of aberration correction, but also from the point of decreasing the size of projection optical system PL, optical adjustment, mechanical design, production cost, and the like. And, by forming the two intermediate images on the concave reflection mirror M1 side of optical path bending mirror FM, the axis decentered amount can be set smaller.

In addition, on reticle R, corresponding to the decentering of effective exposure area IA described above, a rectangular-shaped illumination area (that is, effective illumination area) IAR that has the size and shape corresponding to effective exposure area IA is formed (refer to FIG. 2) at a position a predetermined distance away from optical axis AX in the -Y direction, the distance corresponding to axis decentered amount A.

Of the plurality of optical elements of projection optical system PL, a border lens 192 (hereinafter also appropriately referred to as 'optical element 192'), which is an optical element disposed closest to the wafer except for an end optical element 191, has a convex surface that faces the reticle side. That is, the surface of boarder lens 192 on the reticle side has a positive refracting power. And, on the optical path between border lens 192 and wafer W, end optical element 191 consisting of a parallel plane plate is disposed. Furthermore, the optical path between border lens 192 and end optical element 191 and the optical path between end optical element 191 and wafer W are filled with liquid whose refractive index is larger than 1.1. In the embodiment, each of the optical paths is filled with purified water whose refractive index to the ArF excimer laser beam, that is, illumination light IL having the wavelength of 193 nm, is 1.44. The purified water can transmit, not only the ArF excimer laser beam, but also, for example, bright lines in the ultraviolet region emitted from a mercury lamp (such as the g-line, the h-line, and the i-line) and deep ultraviolet light (DUV light) such as the KrF excimer laser beam (wavelength 248 nm).

In the embodiment, of the plurality of lenses of projection optical system PL, for example, a plurality of specific lenses, such as a plurality of lenses (e.g. five) (hereinafter also referred to as 'movable lenses') including lens 90 closest to reticle R in a plurality of lenses included in the first image-forming optical system G1, is driven by an image-forming characteristics correction controller 52 shown in FIG. 1, based on instructions from main controller 50, and the optical properties (including image-forming characteristics) of the optical system including projection optical system PL that are rotational symmetry image-forming characteristics, such as magnification, distortion, coma, and curvature of image plane, and the optical properties that gradually change from one side to the other side within a plane orthogonal to the optical axis such as the inclination of the image plane can be adjusted. In this case, the term 'rotational symmetry' differs from the usual meaning of 'rotational symmetry' of 'the unchanging nature of a graphic form or the like when the graphic form is rotated around a constant axis (a symmetry axis) at a predetermined angle,' and means 'the unchanging nature of a graphic form or the like when the graphic form is rotated around a constant axis (a symmetry axis) at any angle from 0 to 360 degrees.' Any cases other than this are referred to as non-rotational symmetry. In this description, the terms rotational symmetry and non-rotational symmetry are used in such a sense.

As is obvious from FIG. 2, in projection optical system PL related to the embodiment, in lens 90 closest to reticle R or in end optical element 191, since illumination light IL passes through the area away from optical axis AX, a non-rotational symmetry temperature distribution as in the background art previously described occurs, which generates a non-rotational symmetry image-forming characteristics (aberration) in projection optical system PL (including liquid Lq2) and the optical system including liquid Lq1 (hereinafter referred to as optical system PLL). This non-rotational symmetry aberration substantially cannot be corrected by driving the movable lenses including lens 90 using image-forming characteristics correction controller 52.

In the embodiment, because a parallel plane plate is used as end optical element 191 and the upper surface of the parallel plane plate is in contact with liquid Lq2 while the lower surface is in contact with liquid Lq1, it can be considered that the level of the non-rotational symmetry aberration occurring in optical system PLL due to the uneven temperature distribution in the surface of end optical element 191 is ignorable.

Therefore, in the embodiment, in order to correct the non-rotational symmetry aberration in optical system PLL, as is shown in FIG. 1, a light (hereinafter referred to as non-exposure light) NL (non-exposure lights NLₖ and NLₙ are representatively shown in FIG. 1) for aberration correction whose bandwidth is different from illumination light IL is irradiated on lens 90 of projection optical system PL closest to the reticle. In the description below, a non-exposure light irradiation mechanism 91 for irradiating non-exposure light NL on lens 90 is described.

In the embodiment, as non-exposure light NL, the light in the bandwidth that hardly exposes the resist coated on wafer W is used. Therefore, as non-exposure light NL, as an example, an infrared light is used whose wavelength is, for example, 10.6 µm, by pulse emission from a carbon dioxide laser (CO₂ laser). As the carbon dioxide (CO₂) laser beam, a continuous light can be used. The infrared light having the wavelength of 10.6 µm is greatly absorbed by quartz, and because almost all the infrared light (90% or over is desirable) is absorbed by a single lens in projection optical system PL, such an infrared light is easy to use to control aberration without affecting the other lenses. In addition, non-exposure light NL irradiated on lens 90 of the embodiment is set so that 90% or more is absorbed, and the desired section of lens 90 can be heated effectively. Incidentally, as non-exposure light NL, other than the carbon dioxide laser beam, a near infrared light with the wavelength of around 1 µm emitted from a solid-state laser beam such as a YAG laser, or an infrared light around several µm emitted from a semiconductor laser can also be used. That is, the optimum light source can be employed for the light source that generates non-exposure light NL, according to the material or the like of the optical member (such as the lens) on which non-exposure light NL is irradiated. In addition, although lens 90 is drawn as if it is a convex lens in FIG. 2 or the like, it may also be a concave lens.

As is shown in FIGS. 1 and 2, non-exposure light NL outgoing from a light source system 92 of non-exposure light irradiation mechanism 91 is divided, corresponding respectively to a plurality of (in this case, n (n is to be an integral number that is equal to or greater than eight)) optical paths that lead toward lens 90 and an optical path that leads toward a photoelectric sensor 94 (not shown in FIG. 1, refer to FIG. 2) by a mirror optical system 93. The detection signals corresponding to the light quantity of non-exposure light NL that are detected by photoelectric sensor 94 are fed back to light source system 92. In addition, non-exposure light NL in two of the optical paths of the n optical paths is irradiated on lens 90 as non-exposure light NLₖ and NLₙ, respectively, via two irradiation mechanisms 95ₖ and 95ₙ, which are disposed sandwiching projection optical system PL in the X-axis direction.

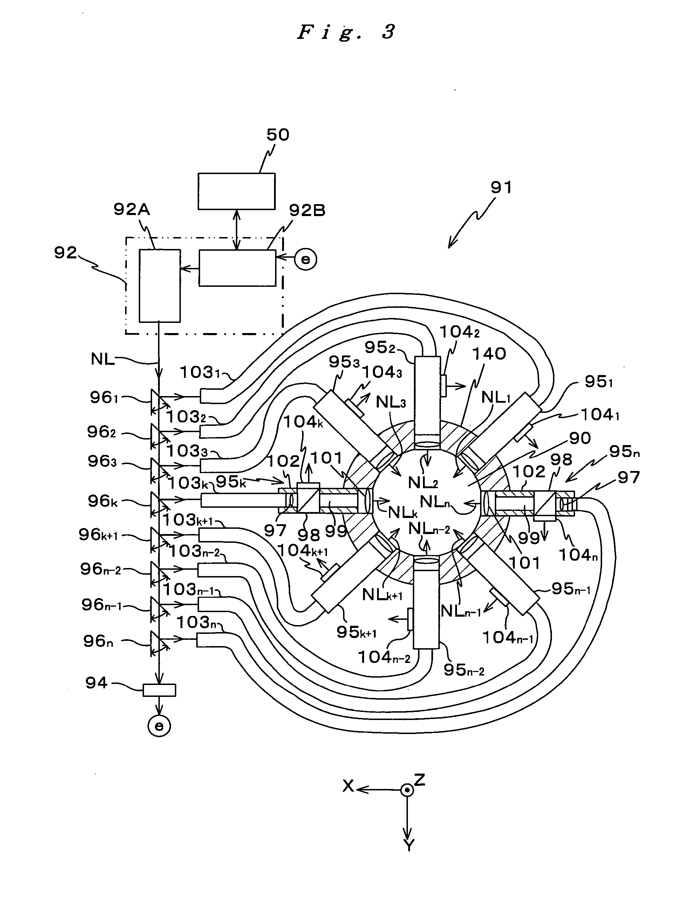

FIG. 3 shows an example of an arrangement of non-exposure light irradiation mechanism 91 in detail. In FIG. 3, light source system 92 includes a light source 92A and a control section 92B. And, non-exposure light NL emitted from light source 92A enters photoelectric sensor 94 after passing through movable mirrors that can be switched at a high speed between either a state where the optical path of non-exposure light NL is bent at an angle of 90 degrees (closed state) or a state where the optical path of non-exposure light NL passes through without being bent (open state), such as, for example, galvano-directing mirrors 96₁, 96₂, ... , 96ₖ, ... 96ₙ₋₁, 96ₙ, and then the detection signals of photoelectric sensor 94 are supplied to control section 92B. Galvano-directing mirrors 96₁ to 96ₙ correspond to mirror optical system 93 in FIG. 1, and control section 92B controls the emission timing and output of light source 92A and the state of the galvano-directing mirrors 96₁ to 96ₙ individually, according to the control information from main controller 50.

In addition, non-exposure light NL whose optical path is bent at each of the n galvano-directing mirrors 96₁ to 96ₙ is guided to irradiation mechanisms 95₁ to 95ₙ, via optical fiber bundles 103₁ to 103ₙ (metal pipes or the like can also be used), respectively.

In this case, although eight galvano-directing mirrors, optical fiber bundles, and irradiation mechanisms are shown in FIG. 3, n (n≧8, n is equal to or greater than 8) galvano-directing mirrors, optical fiber bundles, and irradiation mechanisms actually exist. And, irradiation mechanisms 95ₖ and 95ₙ among the n irradiation mechanisms 95₁ to 95ₙ are each equipped with a condenser lens 97, a beam splitter 98 that has a low predetermined reflectivity, an optical guide 99 consisting of an optical fiber bundle, a relay lens system, or the like, a condenser lens 101, and a holding frame 102 that fixes condenser lens 97 and optical guide 99 to beam splitter 98.

Instead of condenser lens 97, a lens that has a diverging effect can be used to broaden non-exposure light NL. Non-exposure light NL is irradiated on lens 90 of projection optical system PL as non-exposure lights NLₖ and NLₙ from irradiation mechanisms 95ₖ and 95ₙ, respectively. Other irradiation mechanisms from irradiation mechanisms 95₁, 95₂ to 95ₖ₋₁ and irradiation mechanisms 95ₖ₊₁ up to 95ₙ₋₁ are configured in the same manner as irradiation mechanisms 95ₖ and 95ₙ, and non-exposure light NL is irradiated on lens 90 of projection optical system PL as non-exposure lights NL₁, NL₂ to NLₖ₋₁ and as non-exposure lights NLₖ₊₁ up to NLₙ₋₁, from irradiation mechanisms 95₁, 95₂ to 95ₖ₋₁ and irradiation mechanisms 95ₖ₊₁ up to 95ₙ₋₁, respectively.

The optical member on which non-exposure lights NL₁ to NLₙ is irradiated, and the shape and the size of the irradiation area of non-exposure lights NL₁ to NLₙ on the optical member are decided by experiment and simulation so that the non-rotational symmetry aberration is reduced as much as possible. In addition, the optical member on which non-exposure lights NL₁ to NLₙ is irradiated, and the shape and the size of the irradiation area of non-exposure lights NL₁ to NLₙ on the optical member are decided according to the aberration that should be reduced. For example, in FIG. 3, by making the position of the optical members in irradiation mechanisms 95₁ to 95ₙ movable, the shape and the size of the irradiation area of non-exposure lights NL₁ to NLₙ can be changed. Incidentally, an arrangement may also be employed where irradiation mechanisms 95₁ to 95ₙ or the optical members inside irradiation mechanisms 95₁ to 95ₙ are movable so as to adjust the position of the irradiation area of non-exposure lights NL₁ to NLₙ.

In addition, photoelectric sensors 104₁ to 104ₙ are disposed that respectively receive a part of the non-exposure lights reflected off the respective beam splitters 98 in irradiation mechanisms 95₁ to 95ₙ, and the detection signals of the n photoelectric sensors, photoelectric sensors 104₁ to 104ₙ, are also supplied to control section 92B. Control section 92B can accurately monitor the light quantity of non-exposure lights NL₁ to NLₙ just before the lights are irradiated on lens 90 of projection optical system PL from irradiation mechanisms 95₁ to 95ₙ by the detection signals of photoelectric sensors 104₁ to 104ₙ, and according to such monitoring results, control section 92B controls the irradiation amount of non-exposure lights NL₁ to NLₙ so that each of the irradiation amount matches the values, for example, instructed by main controller 50. By measuring the irradiation amount of non-exposure light NL just before projection optical system PL with photoelectric sensors 104₁ to 104ₙ, the irradiation amount of non-exposure lights NL₁ to NLₙ irradiated on lens 90 can be accurately monitored, even if the length (optical path length) of optical fiber bundles 103₁ to 103ₙ varies and furthermore without being affected by the temporal change of the optical system or the like.

In the case of controlling the irradiation amount of non-exposure lights NL₁ to NLₙ according to the monitoring results of photoelectric sensors 104₁ to 104ₙ, it is desirable to have each of the photoelectric sensors 104₁ to 104ₙ calibrated. For example, the temperature distribution of lens 90 when non-exposure lights NL₁ to NLₙ are irradiated on lens 90 can be measured, and each of the photoelectric sensors 104₁ to 104ₙ can be calibrated so that the temperature distribution becomes a desirable state. Or, the state of the image-forming characteristics (aberration) when non-exposure lights NL₁ to NLₙ are irradiated on lens 90 can be measured, and each of the photoelectric sensors 104₁ to 104ₙ can also be calibrated so that the image-forming characteristics (aberration) becomes a desirable state. Furthermore, in the case of performing calibration on the photoelectric sensors, non-exposure lights NL₁ to NLₙ may all be irradiated on lens 90, or a part of non-exposure lights NL₁ to NLₙ (such as, non-exposure lights NLₖ and NLₙ) may be irradiated on lens 90, according to the usage conditions of non-exposure lights NL₁ to NLₙ.

Irradiation mechanisms 95ₖ and 95ₙ are each disposed tilted slightly downward toward lens 90, inside an opening arranged in the vicinity of the upper end section of barrel 140. And, non-exposure lights NLₖ and NLₙ emitted from irradiation mechanisms 95ₖ and 95ₙ enter lens 90 from a direction obliquely intersecting the optical path of illumination light IL. Other irradiation mechanisms in FIG. 3 from irradiation mechanisms 95₁, 95₂ to 95ₖ₋₁ and irradiation mechanisms 95ₖ₊₁ up to 95ₙ₋₁ are disposed in the same manner in the opening of barrel 140 at the same gradient angle, and non-exposure lights NL₁, NL₂ to NLₖ₋₁ and non-exposure lights NLₖ₊₁ up to NLₙ₋₁ from irradiation mechanisms 95₁, 95₂ to 95ₖ₋₁ and irradiation mechanisms 95ₖ₊₁ up to 95ₙ₋₁ also enter lens 90 from a direction obliquely intersecting the optical path of illumination light IL.

Because non-exposure lights NL₁ to NLₙ can each be irradiated toward the optical axis of illumination light IL so that each of non-exposure lights NL₁ to NLₙ intersect with the optical path of illumination light IL, a part of the optical members (lens 90) of projection optical system PL can be effectively irradiated without the non-exposure lights passing through other optical members of projection optical system PL. Furthermore, because the optical path of non-exposure lights NL₁ to NLₙ on lens 90 becomes longer and non-exposure lights NL₁ to NLₙ are almost all absorbed by lens 90, non-exposure lights NL₁ to NLₙ hardly enter other optical members of projection optical system PL, which substantially ceases the emission of non-exposure lights NL₁ to NLₙ from projection optical system PL.

In addition, because non-exposure light NL is irradiated partially on the optical surface of a part of the optical members (lens 90) of projection optical system PL, or in other words, on the area where illumination light IL can enter (or exit), the temperature distribution of lens 90, or furthermore, the image-forming characteristics of projection optical system PL can be adjusted more effectively, within a shorter period of time.

Incidentally, irradiation mechanisms 95ₖ and 95ₙ (similar in other irradiation mechanisms; irradiation mechanisms 95₁, 95₂ to 95ₖ₋₁ and irradiation mechanisms 95ₖ₊₁ up to 95ₙ₋₁) may also be disposed inside the opening arranged in barrel 140, tilted slightly upward to lens 90 so that non-exposure lights NLₖ and NLₙ illuminate the bottom surface (lower surface, outgoing surface) of lens 90. In this case, the amount of non-exposure lights NLₖ and NLₙ that leaks from the wafer side of projection unit PU can be further reduced.

In the embodiment, non-exposure light irradiation mechanism 91 is configured including light source 92A, control section 92B, galvano-directing mirrors 96₁ to 96ₙ, optical fiber bundles 103₁ to 103ₙ, irradiation mechanisms 95₁ to 95ₙ, photoelectric sensors 104₁ to 104ₙ, and the like. And, for example, in the case of irradiating only two non-exposure lights NLₖ and NLₙ on lens 90, the operation of closing galvano-directing mirror 96ₖ (a state that reflects non-exposure light) for a predetermined period from a state where galvano-directing mirrors 96₁ to 96ₙ are all open (a state that allows non-exposure light to pass) and the operation of closing galvano-directing mirror 96ₙ for a predetermined period is to be repeated alternately. By switching the galvano-directing mirror in a sufficiently short time (such as 1 msec) so that it does not affect the aberration, the influence on the aberration can be removed. In addition, because non-exposure light NL of the embodiment is a pulsed light, the open/close operation of galvano-directing mirrors 96₁ to 96ₙ can be performed with a predetermined pulse number serving as a unit. Similarly, in the case of irradiating other non-exposure lights on lens 90, the closing operation of the corresponding galvano-directing mirror for a predetermined period and the opening operation can be repeated alternately. As is described above, by using galvano-directing mirrors 96₁ to 96ₙ, a plurality of points on the lens surface of lens 90 can be irradiated effectively at a desired light quantity in a state where there is almost no light quantity loss of non-exposure light NL.

The number of areas or the position where non-exposure light NL irradiates (the number or the position of the irradiation mechanisms) is decided, according to the light quantity distribution of illumination light IL within projection optical system PL, the type of aberration adjusted by non-exposure light NL, the permissible value of the aberration and the like.

In addition, in the embodiment, instead of using galvano-directing mirrors 96₁ to 96ₙ, for example, non-exposure light NL can be divided into a plurality of light beams by combining a fixed mirror and a beam splitter, and these beams can be opened or closed using a shutter. In this arrangement, a plurality of points can be irradiated by non-exposure light NL at the same time. Furthermore, for example, in the case of using a carbon dioxide laser or a semiconductor laser as the light source, the same number of light sources as the number of irradiation areas required for lens 90 (eight in FIG. 3) can be prepared, and the number of irradiation areas, the irradiation amount on each irradiation area, and the like on lens 90 where non-exposure light NL is irradiated can be controlled directly by the on/off operation of the light sources or by using shutters.

Furthermore, for example, under dipole illumination (bipolar illumination) or other modified illumination conditions, illumination light IL passes an area eccentric from optical axis AX on the pupil plane of projection optical system PL, which generates a non-rotational symmetry temperature distribution in the first pupil PP1, the second pupil PP2, and the third pupil PP3 of projection optical system PL. Such a non-rotational symmetry temperature distribution causes a non-rotational symmetry aberration (change) of projection optical system PL (optical system PLL).

Taking into consideration such points, as is shown in FIG. 2, in exposure apparatus 100 of the embodiment, a non-exposure light irradiation mechanism 91A is arranged that irradiates a light for aberration correction in a wavelength band different from illumination light IL (hereinafter referred to as non-exposure light) on lens 111 located in the vicinity of the second pupil PP2. As the non-exposure light irradiated by non-exposure light irradiation mechanism 91A, a light in the bandwidth that hardly exposes the resist coated on wafer W is used, such as, for example, an infrared light whose wavelength is, for example, 10.6 µm, outgoing from a carbon dioxide laser (CO₂ laser) by pulse emission. In the description below, the non-exposure light irradiated from non-exposure light irradiation mechanism 91A will be stated as non-exposure light NE.

Incidentally, as non-exposure light NE, other than the carbon dioxide laser beam, a near infrared light with the wavelength of around 1 µm emitted from a solid-state laser beam such as a YAG laser, or an infrared light around several µm emitted from a semiconductor laser can also be used. That is, the optimum light source can be employed for the light source that generates non-exposure light NE, according to the material of the optical member (such as the lens) on which non-exposure light NE is irradiated.

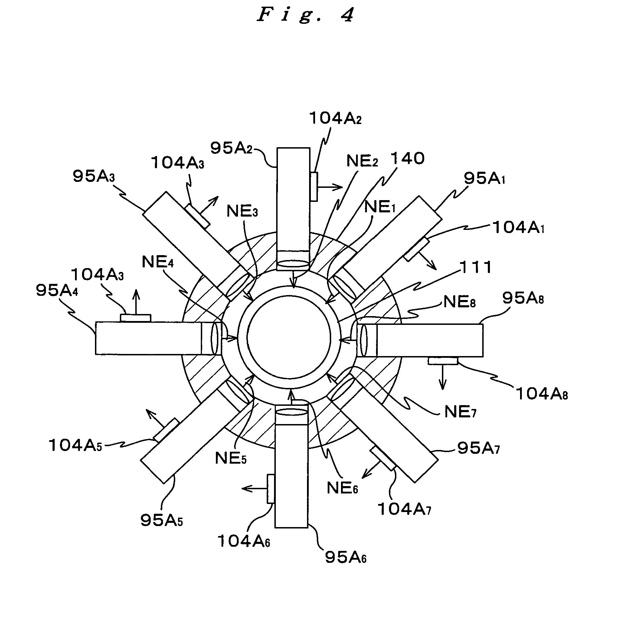

Similar to non-exposure light irradiation mechanism 91 described earlier, non-exposure light irradiation mechanism 91A is equipped with a light source system 92', a mirror optical system 93A, a photoelectric sensor 94A, and a plurality of (in this case, eight) irradiation mechanisms 95A₁ to 95A₈ (refer to FIG. 4), and the like. Similar to light source system 92 previously described, light source system 92' includes a light source and a control section. In addition, similar to mirror optical system 93 previously described, mirror optical system 93A is constituted by a plurality of, or in this case, eight movable mirrors such as galvano-directing mirrors that can switch a state at a high speed between a state where the optical path of non-exposure light NE is bent at an angle of 90 degrees (closed state) and a state where the optical path of non-exposure light NL passes through without being bent (open state).

Non-exposure light NE whose optical path is sequentially bent by the eight galvano-directing mirrors is guided to irradiation mechanisms 95A₁ to 95Aₙ (95A₈) that are shown in FIG. 4, which shows the section of projection unit PU along a line B-B in FIG. 2, respectively, via optical fiber bundles (not shown). Irradiation mechanisms 95A₁ to 95A₈ have a configuration similar to irradiation mechanism 95 previously described, and can each adjust the position, the size, and the shape of the irradiation areas of non-exposure lights NE₁ to NE₈. As is shown in FIG. 4, the outgoing end of irradiation mechanisms 95A₁ to 95A₈ is attached to barrel 140 disposed in a state facing the side surface of lens 111 (the lens that is located in the vicinity of the second pupil PP2 as well as constitutes a part of the second image-forming optical system G2). Accordingly, irradiation mechanisms 95A₁ to 95A₈ are configured so that non-exposure lights NE₁ to NE₈ can each be irradiated on the side surface of lens 111. In the embodiment, because the non-exposure lights (NE₁ to NE₈) are irradiated on the side surface of lens 111, the irradiation area of the non-exposure lights (NE₁ to NE₈) is an elliptical shape elongated in the circumferential direction.

The control section that constitutes a part of light source system 92' controls the emission timing and output of the light source and the state of the galvano-directing mirrors, according to the control information from main controller 50.

In addition, photoelectric sensors 104A₁ to 104A₈ are disposed that respectively receive a part of non-exposure lights NE reflected off each of the beam splitters that constitute a part of irradiation mechanisms 95A₁ to 95Aₙ, and the detection signals of the eight photoelectric sensors, photoelectric sensors 104₁ to 104₈, are also supplied to the control section constituting a part of light source system 92'. The control section can accurately monitor the light quantity of non-exposure lights NE₁ to NE₈ just before the lights are irradiated on lens 111 of projection optical system PL from irradiation mechanisms 95A₁ to 95A₈ by the detection signals of photoelectric sensors 104A₁ to 104A₈, and based on such monitoring results, the control section controls the irradiation amount of non-exposure lights NL₁ to NLₙ so that each of the irradiation amount, for example, matches the values instructed by main controller 50.

In the case of controlling the irradiation amount of non-exposure lights NE₁ to NE₈ according to the monitoring results of photoelectric sensors 104A₁ to 104A₈, it is desirable to have each of the photoelectric sensors 104A₁ to 104A₈ calibrated, as is previously described. In addition, in the embodiment, the number of the irradiation mechanisms (95A₁ to 95A₈) of non-exposure light irradiation mechanism 91A is not limited to eight, however, the temperature (temperature distribution) of lens 111 can be controlled with higher precision when there are more numbers of irradiation mechanisms.

In addition, as in the case of non-exposure light irradiation mechanism 91 previously described, the number, the position, the shape, the size, and the irradiation amount of the non-exposure light (NE₁ to NE₈) irradiated on lens 111 from the irradiation mechanisms (95A₁ to 95A₈) are decided, according to the light quantity distribution of illumination light IL in lens 111, the type of aberrations adjusted by irradiating the non-exposure light (NE₁ to NE₈), the permissible value of the aberration, and the like.

Referring back to FIG. 1, wafer stage WST is disposed below projection optical system PL and above a base (not shown), and is moved freely within an XY plane (including rotation around the Z-axis (the θz rotation)) by a wafer stage drive system 56 that includes a linear motor or the like. In addition, wafer stage WST is finely moved in a Z-axis direction and a direction of inclination with respect to the XY plane (rotation direction around the X-axis (θx direction) and the rotation direction around the Y-axis (θy direction)) by an actuator, which is a part of wafer stage drive system 56. Wafer stage drive system 56 can also be equipped with an actuator that finely moves wafer stage WST within the XY plane, in addition to the Z-axis direction and the direction of inclination with respect to the XY plane.

The position and the rotation (yawing (the θz rotation, which is the rotation around the Z-axis), pitching (the θx rotation, which is the rotation around the X-axis), and rolling (the θy rotation, which is the rotation around the Y-axis)) of wafer stage WST within the XY plane is detected constantly by a wafer laser interferometer 54, using a reflection surface arranged in wafer stage WST.

The position information (or speed information) on wafer stage WST is supplied to main controller 50. Main controller 50 controls wafer stage WST according to the position information (or speed information), via wafer stage drive system 56.

At a predetermined position on wafer stage WST, a fiducial member (not shown) that has a plurality of fiducial marks is arranged. In addition, in the vicinity of wafer W on wafer stage WST an illuminance sensor 21P like the one disclosed in, for example, Kokai (Japanese Unexamined Patent Application Publication) No. 57-117238 and the corresponding U.S. Patent No. 4,465,368 or the like, is arranged for measuring the irregularity of illuminance. The light-receiving surface of illuminance sensor 21P is set at the same height as the surface of wafer W, and a pinhole-shaped light-receiving section (not shown) is formed. Furthermore, on wafer stage WST, an irradiance monitor 58 on which a light-receiving section larger than exposure area IA is formed, such as the one disclosed in, for example, Kokai (Japanese Unexamined Patent Application Publication) No. 11-16816 and the corresponding U.S. Patent Application Publication No. 2002/0061469, is installed in a state where its light-receiving surface is positioned in plane with the surface of wafer W. And, by irradiance monitor 58 and illuminance sensor 21P, illumination light IL passing through projection optical system PL can be received on the image plane or on the neighboring plane of projection optical system PL.

As irradiance monitor 58 and illuminance sensor 21P, photoelectric conversion elements such as a photodiode or a photomultiplier that is sensitive to the same wavelength range as illumination light IL (for example, wavelength around 300 to 100 nm) and has high response frequency can be used. The detection signals (photoelectric conversion signals) of irradiance monitor 58 and illuminance sensor 21P are supplied to main controller 50 via a hold circuit and an analog-digital (A/D) converter (not shown), and the like. The disclosures of the Kokai publications and the U. S. Patents described above are fully incorporated herein by reference.

The liquid immersion mechanism is equipped with a first liquid supply unit 68, a second liquid supply unit 72, a first liquid recovery unit 69, a second liquid recovery unit 73 and a nozzle member 70, a piping system and the like connecting each of the sections.

Nozzle member 70 is a ring-shaped member that is arranged above wafer W (wafer stage WST) so that it surrounds the lower end section of barrel 140. Nozzle member 70 is supported by a main column (not shown), which holds projection unit PU via a vibration isolation unit (not shown), via a support member (not shown).

The first liquid supply unit 68 connects to nozzle member 70 via a supply pipe 66. The first liquid supply unit 68 is for supplying liquid Lq1 to a first space K1 (refer to FIG. 5) between end optical element 191 (refer to FIG. 5) closest to the image plane of projection optical system PL and wafer W (wafer stage WST) via supply pipe 66. The first liquid supply unit 68 includes a tank for holding liquid Lq1, a temperature adjustment unit for adjusting the temperature of liquid Lq1 that is to be supplied, a filtering unit for removing foreign materials in liquid Lq1, a compression pump, a flow amount control valve for controlling the flow amount of liquid Lq1 to be supplied, and the like. The first liquid supply unit 68 operates under the control of main controller 50, and supplies liquid Lq1 on wafer W when an immersion area AR (refer to FIG. 5) is formed on wafer W. Incidentally, the tank, the temperature adjustment unit, the filtering unit, and the compression pump do not all have to be arranged in the first liquid supply unit 68 of exposure apparatus 100, and at least a part of such parts can be substituted by the equipment available in the factory where exposure apparatus 100 is installed.

The first liquid recovery unit 69 connects to nozzle member 70 via a recovery pipe 67. The first liquid recovery unit 69 is for recovering liquid Lq1 supplied to the first space K1. The first liquid recovery unit 69 includes a vacuum system (suction unit) such as, for example, a vacuum pump, a gas-liquid separator for separation of liquid and gas in liquid Lq1 that has been recovered, a tank for holding liquid Lq1 that has been recovered, a flow amount control valve for controlling the flow amount of liquid to be recovered, and the like. Incidentally, exposure apparatus 100 does not all have to be equipped with the vacuum system, the gas-liquid separator, the tank, and the flow amount control valve and these parts can be partially substituted by the equipment available in the factory where exposure apparatus 100 is installed. The first liquid recovery unit 69 operates under the control of main controller 50, and recovers liquid Lq1 on wafer W supplied from the first liquid supply unit 68 so as to form immersion area AR on wafer W by a predetermined amount.

The second liquid supply unit 72 connects to a side surface of barrel 140 on the +Y side at a position slightly above nozzle member 70, via a supply pipe 74. The second liquid supply unit 72 is for supplying liquid Lq2 to a second space K2 (refer to FIG. 5) formed on the upper surface side of end optical element 191 of projection optical system PL. The second liquid supply unit 72 includes a tank for holding liquid Lq2, a temperature adjustment unit for adjusting the temperature of liquid Lq2 that is to be supplied, a filtering unit for removing foreign materials in liquid Lq2, a compression pump, and the like. Incidentally, the tank, the temperature adjustment unit, the filtering unit, and the compression pump do not all have to be arranged in the second liquid supply unit 72 of exposure apparatus 100, and at least a part of such parts can be substituted by the equipment available in the factory where exposure apparatus 100 is installed.

The second liquid recovery unit 73 connects to a side surface of barrel 140 on the -Y side at a position slightly above nozzle member 70, via a recovery pipe 75. The second liquid recovery unit 73 is for recovering liquid Lq2 supplied to the second space K2. The second liquid recovery unit includes a vacuum system (suction unit) such as, for example, a vacuum pump, a gas-liquid separator for separation of liquid and gas in liquid Lq2 that has been recovered, a tank for holding liquid Lq2 that has been recovered, and the like. Incidentally, exposure apparatus 100 does not all have to be equipped with the vacuum system, the gas-liquid separator, and the tank and these parts can be at least partially substituted by the equipment available in the factory where exposure apparatus 100 is installed.

FIG. 5 shows a sectional view of the image plane side of projection optical system PL and the vicinity of nozzle member 70, whereas FIG. 6 shows a view of nozzle member 70 when viewed from below. The configuration and the like of nozzle member 70 and its vicinity will now be described, according to FIGS. 5 and 6.

In FIGS. 5 and 6, end optical element 191 and border lens 192, which is disposed above end optical element 191, are supported by barrel 140. End optical element 191 is a plane-parallel plate and the lower surface of end optical element 191, lower surface 191a, is arranged substantially flush with the lower surface of barrel 140, lower surface 140a. The upper surface of end optical element 191, upper surface 191b supported by barrel 140 and lower surface 191a is substantially parallel with the XY plane. Further, end optical element (plane-parallel plate) 191 is supported in a substantially horizontal manner, and has no refractive power. In addition, the gap between barrel 140 and end optical element 191 is sealed. More specifically, the first space K1 on the lower side of end optical element 191 and the second space K2 on the upper side of end optical element 191 are both independent spaces, and the liquid flow is blocked between the first space K1 and the second space K2. As is described above, the first space K1 is the space between end optical element 191 and wafer W (or wafer stage WST), and liquid Lq1 in the first space K1 forms immersion area AR. Meanwhile, the second space K2 is a part of the inner space of barrel 140, and is the space between the upper surface 191b of end optical element 191 and a lower surface 192a of boarder lens 192 arranged above the upper surface 191b of end optical element 191.

Incidentally, end optical element 191 can be easily attached to or detached from barrel 140. That is, an arrangement where end optical element 191 is exchangeable is employed.

As is shown in FIG. 5, nozzle member 70 is arranged so as to enclose the lower end section of barrel 140 above wafer W (wafer stage WST), which is disposed facing projection unit PU. Nozzle member 70 has a hole section 70h in which the bottom section of projection unit PU (barrel 140) can be disposed in the center via a predetermined gap. In the embodiment, the projection area of projection optical system PL, or in other words, effective exposure area IA is set in a rectangular shape whose longitudinal direction is in the X-axis direction (non-scanning direction), as is shown in FIG. 6.

On a lower surface 70a of nozzle member 70 facing wafer W, a depressed section 78 whose longitudinal direction is in the X-axis direction is formed in the center. In the center of an inner bottom surface 78a of depressed section 78, the opening end of hole section 70h described earlier is formed. Inner bottom surface 78a of depressed section 78 is roughly parallel to the XY plane, and serves as a cavity plane that faces wafer W supported by wafer stage WST. Further, a sidewall inner surface 78b of depressed section 78 is arranged substantially orthogonal to the XY plane.

In sidewall inner surface 78b of depressed section 78 formed on the lower surface 70a of nozzle member 70, first supply openings 80a and 80b are formed on both sides in the Y-axis direction, respectively, with end optical element 191 (projection area IA) of projection optical system PL in between. The first supply openings 80a and 80b connect respectively to one end of a first supply passage 82 formed inside nozzle member 70. The other end of the first supply passage 82 connects to one end of supply pipe 66 previously described, and the end section opposite to the side connected to supply pipe 66 divides into a plurality of (two) branches, and each of the branched ends connect to a plurality of (two) supply openings, the first supply openings 80a and 80b, respectively.

The liquid supply operation of the first liquid supply unit 68 is controlled by main controller 50. In order to make immersion area AR, main controller 50 delivers liquid Lq1 from the first liquid supply unit 68. Liquid Lq1 sent out from the first liquid supply unit 68 flows into an end section of the first supply passage 82 formed inside nozzle member 70, after flowing through supply pipe 66. Then, liquid Lq1 that flows into the end section of the first supply passage 82 formed inside nozzle member 70 is supplied to the first space K1 between end optical element 191 and wafer W from the plurality of (two) supply openings, the first supply openings 80a and 80b, formed in nozzle member 70. In the embodiment, liquid Lq1 supplied from the first supply openings 80a and 80b comes out substantially parallel to the surface of wafer W, however, the first supply opening can be formed so that liquid Lq1 is supplied in a downward direction.

Further, the first supply opening can be arranged on both sides of end optical element 191 in the X-axis direction, or the first supply opening may be arranged in one spot.

In lower surface 70a of nozzle member 70, on the outer side of depressed section 78 with projection area IA of projection optical system PL serving as a datum, a first recovery opening 81 is arranged. The first recovery opening 81 is arranged in lower surface 70a of nozzle member 70 facing wafer W, on the outer side of the first supply openings 80a and 80b with respect to projection area IA of projection optical system PL, and is formed in a ring shape so that the first recovery opening 81 surrounds projection area IA and the first supply openings 80a and 80b. Further, in the first recovery opening 81, a porous-body 81P is arranged.

As is shown in FIG. 5, one end section of recovery pipe 67 previously described connects to one end section of a manifold passage 83M constituting a part of a first recovery passage 83 formed in the inside of nozzle member 70. Meanwhile, the other end section of manifold passage 83M connects to a part of a circular passage 83K that constitutes a part of the first recovery passage 83 connecting to the first recovery opening 81.

Main controller 50 controls the liquid recovery operation of the first liquid recovery unit 69. In order to recovery liquid Lq1, main controller 50 drives the first liquid recovery unit 69. By driving the first liquid recovery unit 69, liquid Lq1 on wafer W flows through passage 83 via the first recovery opening 81, which is arranged in lower surface 70a of nozzle member 70. Then, liquid Lq1 is recovered by suction by the first liquid recovery unit 69, via recovery pipe 67.

In a sidewall inner surface 140c of barrel 140, a second supply opening 86 is arranged. The second supply opening 86 is formed at a position in the vicinity of the second space K2, and is arranged on the +Y side of optical axis AX of projection optical system PL. The second supply opening 86 connects to one end of a second supply passage 84 formed inside the sidewall of barrel 140, and the other end section of the second supply passage 84 connects to one end of supply pipe 74 previously described.

Further, at a position substantially facing the second supply opening 86 in sidewall inner surface 140c of barrel 140, a second recovery opening 87 is arranged. The second recovery opening 87 is formed at a position in the vicinity of the second space K2, and is arranged on the -Y side of optical axis AX of projection optical system PL. The second recovery opening 87 connects to one end of a second recovery passage 85 formed inside the sidewall of barrel 140, and the other end section of the second recovery passage 85 connects to one end of supply pipe 75 previously described.

Main controller 50 controls the liquid supply operation of the second liquid supply unit 72. When main controller 50 delivers liquid Lq2 from the second liquid supply unit 72, liquid Lq2 sent out from the second liquid supply unit 72 flows into an end section of the second supply passage 84 formed inside barrel 140, after flowing through supply pipe 74. Then, liquid Lq2 that flows into the end section of the second supply passage 84 is supplied to the second space K2 between border lens (optical element) 192 and end optical element 191 from the second supply opening 86 formed on side wall inner surface 140c of barrel 140. In this case, from the second supply opening 86, liquid Lq2 comes out substantially parallel to upper surface 191b of end optical element 191, or in other words, substantially parallel to the XY plane (in a lateral direction).

Main controller 50 controls the liquid recovery operation of the second liquid recovery unit 73. In order to recover liquid Lq2, main controller 50 drives the second liquid recovery unit 73. By driving the second liquid recovery unit 73, liquid Lq2 in the second space K2 flows into the second recovery passage 85 via the second recovery opening 87. Then, liquid Lq2 is recovered by suction by the second liquid recovery unit 73, via recovery pipe 75.

In the embodiment, passages 84 and 85 are formed inside the sidewall of barrel 140. However, a through hole may be made in a part of barrel 140, and a piping serving as the passages may be put in the through hole. Further, in the embodiment, supply pipe 74 and recovery pipe 75 are arranged separately from nozzle member 70. However, instead of supply pipe 74 and recovery pipe 75, a supply path and a recovery path can be arranged inside nozzle member 70, connecting to passages 84 and 85 formed inside barrel 140, respectively. The structure and arrangement of the immersion mechanism (nozzle member 70, liquid supply units 68 and 72, liquid recovery units 69 and 73, and the like) are not limited to the ones described above, and various forms of immersion mechanisms can be applied, as long as the predetermined space including the optical path of illumination light IL can be filled with liquid.

With lower surface 192a of boarder lens 192 and upper surface 191b of end optical element 191, liquid Lq2 filled in the second space K2 comes into contact, whereas with lower surface 191a of end optical element 191, liquid Lq1 in the first space K1 comes into contact. In the embodiment, at least optical elements 191 and 192 are made of quartz. And since quartz has a high affinity for liquids Lq1 and Lq2, that is, purified water, liquid Lq2 can be made to come into close contact with substantially the entire surface of lower surface 192a of boarder lens 192 and upper surface 191b of end optical element 191, and liquid Lq1 can be made to come into close contact with substantially the entire surface of lower surface 191a of end optical element 191, each serving as a liquid contact surface. Accordingly, the optical path between optical element 192 and end optical element 191, and the optical path between end optical element 191 and wafer W can be filled with liquids Lq2 and Lq1 without fail, by making liquid Lq2 come into close contact with liquid contact surface 192a of optical element 192 and liquid contact surface 191b of end optical element 191, and by making liquid Lq1 come into close contact with liquid contact surface 191a of end optical element 191.

Incidentally, at least one of optical elements 192 and 191 can be fluorite that has a high affinity for water. Further, for example, the remaining optical elements can be made of fluorite while optical elements 192 and 192 are made of quartz, or the optical elements can all be made of quartz (or fluorite).

Further, on liquid contact surfaces 192a, 191b, and 191a of optical elements 192 and 191, a hydrophilic (lyophilic) treatment can be processed so as to further increase the high affinity for liquid Lq2 and Lq1.

Further, in the embodiment, sidewall inner surface 140c of barrel 140 and sidewall 192b of border lens 192 each have liquid repellency due to liquid repellent treatment. Making sidewall inner surface 140c of barrel 140 and sidewall 192b of border lens 192 liquid repellent prevents liquid Lq2 in the second space K2 from entering the gap formed between sidewall inner surface 140c and sidewall 192b.

As the liquid repellent treatment referred to above, for example, treatment of coating a liquid repellent material such as fluorinated resin material as in polytetrafluoroethylene, acrylic resin material, silicon resin material, or the like, or applying a thin film made of such liquid repellent material can be performed.

Further, liquid repellent treatment can be performed on both a sidewall outer surface 140b of barrel 140 and a sidewall inner surface 70k of hole section 70h of nozzle member 70. By making sidewall outer surface 140b and sidewall inner surface 70k liquid repellent, liquid Lq1 in the first space K1 can be kept from entering the gap formed between sidewall outer surface 140b and sidewall inner surface 70k.

The control system includes main controller 50 in FIG. 1, and main controller 50 is composed including a so-called microcomputer (or a minicomputer) consisting of a CPU (Central Processing Unit), a ROM (Read Only Memory), a RAM (Random Access Memory), and the like. Main controller 50 has overall control over the entire apparatus.

Next, the operations on exposure in exposure apparatus 100 of the embodiment will be described.

When exposure of wafer W is performed, main controller 50 controls the second liquid supply unit 72 and supplies liquid Lq2 to the second space K2. At this point, main controller 50 performs the supply and recovery of liquid Lq2 by the second liquid supply unit 72 and the second liquid recovery unit 73, while optimally controlling the supply amount of liquid Lq2 per unit time by the second liquid supply unit 72 and the recovery amount of liquid Lq2 per unit time by the second liquid recovery unit 73, and fills at least the optical path of illumination light IL in the second space K2 with liquid Lq2.

Further, after wafer W is loaded on wafer stage WST at the loading position (wafer exchange position), main controller 50 moves wafer stage WST holding wafer W to a position under projection optical system PL, that is, the exposure position. Then, in a state where wafer stage WST faces end optical element 191 of projection optical system PL, main controller 50 performs the supply and recovery of liquid Lq1 by the first liquid supply unit 68 and the first liquid recovery unit 69, while optimally controlling the supply amount of liquid Lq1 per unit time by the first liquid supply unit 68 and the recovery amount of liquid Lq1 per unit time by the first liquid recovery unit 69. And, main controller 50 forms immersion area AR of liquid Lq1 on at least the optical path of illumination light IL in the first space K1, and fills the optical path of illumination light IL with liquid Lq1.

Then, before performing exposure of wafer W, main controller 50 performs mark measurement of marks formed on fiducial members arranged on wafer stage WST as well as various measurement operations (including at least preparatory operations for measuring the irradiation amount and preparatory operations for measuring the wafer reflectivity, which are described earlier) using illuminance sensor 21P, irradiance monitor 58, and the like previously described, and based on the measurement results, main controller 50 performs alignment of wafer W and calibration such as image-forming characteristics adjustment of projection optical system PL. For example, in the case of performing measurement operations using illuminance sensor 21P or irradiance monitor 58, by moving wafer stage WST in the XY direction, main controller 50 relatively moves wafer stage WST with respect to immersion area AR of liquid Lq1 so as to form immersion area AR of liquid Lq1 on the light-receiving surface of the sensors, and then performs measurement operations via liquid Lq1 while maintaining such a state.

After the alignment and calibration described above has been performed, while main controller 50 recovers liquid Lq1 on wafer W by the first liquid recovery unit 69 in parallel with supplying liquid Lq1 to the space on wafer W by the first liquid supply unit 68, main controller 50 also projects the pattern image of reticle R on wafer W whose surface is coated with a resist, via projection optical system PL (including liquid Lq2) and liquid Lq1 (that is, the liquid in immersion area AR) in the first space K1, while moving wafer stage WST, which supports wafer W, in the Y-axis direction (scanning direction). In this case, main controller 50 suspends the liquid supply operation by the second liquid supply unit 72 and the liquid recovery operation by the second liquid recovery unit 73 by the beginning of exposure at the latest, and at least the optical path of illumination IL is in a state filled with liquid Lq2 in the second space K2.

Exposure apparatus 100 of the embodiment projects the pattern image of reticle R on wafer W while moving reticle R and wafer W in the Y-axis direction (scanning direction), and in exposure apparatus 100, during the scanning exposure, a part of the pattern image of reticle R is projected within projection area IA via projection optical system PL (including liquid Lq2) and liquid Lq1 in the first space, and in sync with reticle R that moves in the -Y direction (or the +Y direction) with respect to illumination area IAR at a velocity V, wafer W moves in the +Y direction (or the -Y direction) with respect to projection area IA at a velocity β*V (β is the projection magnification). On wafer W, a plurality of shot areas are set, and after exposure of one shot area has been completed, wafer W is stepped to the scanning starting position of the next shot area, and thereinafter, scanning exposure of each shot area is sequentially performed while moving wafer W by the step-and-scan method.

In the embodiment, main controller 50 executes an estimated calculation per time Δt, on the irradiation variation in the image-forming characteristics (various aberrations (including focus)) of optical system PLL caused by the illumination light absorption in projection optical system PL (including liquid Lq2) previously described. And, based on the estimated calculation of the image-forming characteristics, main controller 50 controls the exposure operation.

For example, main controller 50 performs the estimated calculation referred to above per time Δt so as to perform the estimated calculation of the irradiation variation in focus, curvature of image plane, magnification, distortion, coma, and spherical aberration. Then, based on the results of the estimated calculation, main controller 50 obtains the drive amount of each movable lens for correcting the change in the image-forming characteristics by the method similar to the one disclosed in, for example, Kokai (Japanese Unexamined Patent Application Publication) No. 11-258498, and by driving each movable lens according to the drive amount, main controller 50 sequentially corrects the irradiation variation in at least one of the curvature of image plane, magnification, distortion, coma, and spherical aberration of the optical system.

Further, each time the irradiation variation of the image-forming characteristics other than focus is corrected via image-forming characteristics correction controller 52, main controller 50 computes the focus change of the optical system by performing the calculation disclosed in, for example, Kokai (Japanese Unexamined Patent Application Publication) No. 11-258498 described above, and executes auto-focus control of wafer W in which wafer stage WST is driven in the Z-axis direction so as to make the focus error substantially zero.

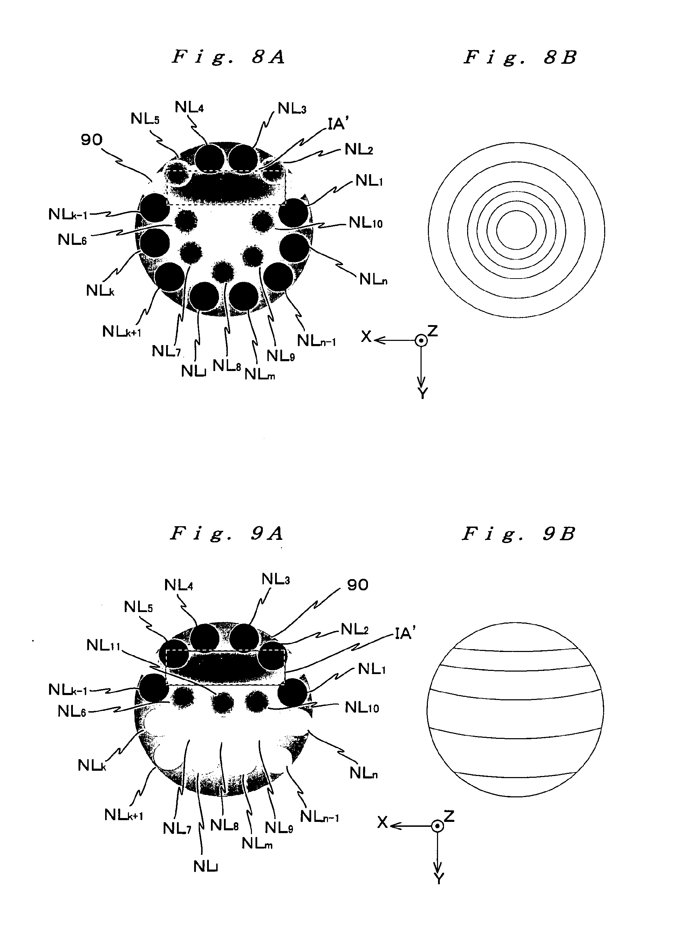

In exposure apparatus 100 of the embodiment, because a catadioptric system like the one shown in FIG. 2 is used as projection optical system PL, a temperature distribution similar to the one shown in FIG. 16A occurs in lens 90 of projection optical system PL located closest to the reticle due to the irradiation of illumination light IL on exposure. Therefore, in exposure apparatus 100 of the embodiment, in order to keep the non-rotational symmetry image-forming characteristics previously described from occurring in projection optical system PL (optical system PLL) due to the temperature distribution and to generate image-forming characteristics (aberrations) that can be easily be corrected (or so that an immediate conversion to image-forming characteristics that can be easily corrected is performed when non-rotational symmetry image-forming characteristics as in the ones previously described occur), control section 92B in light source system 92 of non-exposure light irradiation mechanism 91 controls the irradiation position and the irradiation amount of non-exposure lights NL₁ to NLₙ to lens 90 from irradiation mechanisms 95₁ to 95ₙ, according to instructions from main controller 50. As an example, as is shown in FIG. 8A, control section 92B irradiates non-exposure lights NL₁, NL₃, NL₄, NLₖ₋₁, NLₖ, NLₖ₊₁, NL₁, NLₘ, NLₙ₋₁, and NLₙ at a first light intensity in the vicinity of the outer periphery section of lens 90 and non-exposure lights NL₂ and NL₅ at a second intensity (less than the first intensity) on both sides of non-exposure lights NL₃ and NL₄ in the vicinity of the outer periphery section of lens 90. Control section 92B also irradiates non-exposure lights NL₆, NL₇, NL₈, NL₉, and NL₁₀ at the second intensity on the inner side of non-exposure lights NLₖ₋₁, NLₖ, NLₖ₊₁, NL₁, NLₘ, NLₙ₋₁, NLₙ and NL₁. As a result, a rotational symmetry aberration (change) with the optical axis as the center such as the one shown in FIG. 8B occurs in projection optical system PL (and, as a result, in optical system PLL).

Next, main controller 50 drives at least one of the five movable lenses including lens 90 via image-forming characteristics correction controller 52 in the optical axis AX1 direction, so as to correct the rotational symmetry aberration (change) generated in projection optical system PL, or consequently in optical system PLL. With this operation, the rotational symmetry aberration (change) generated in optical system PLL is corrected in the manner similar to the case of the irradiation variation component previously described. This correction may, as a matter of course, be performed during exposure, or the correction can also be performed when exposure is not being performed.

Or, according to the instructions from main controller 50, control section 92B inside light source system 92 of non-exposure light irradiation mechanism 91 can irradiate non-exposure lights NL₁, NL₂, NL₃ NL₄, NL₅, and NLₖ₋₁ at the first light intensity on the -X side, the -Y side, and the +X side of illumination area IA' of illumination light IL in the vicinity of the outer periphery section of lens 90, for example, as is shown in FIG. 9A. Control section 92B can also irradiate non-exposure lights NL₆, NL₁₁, and NL₁₀ at the second intensity (less than the first intensity) on the +Y side of illumination area IA' of illumination light IL, irradiate non-exposure lights NLₖ, NL₇, NL₈, NL₉, and NLₙ at a third intensity (less than the second intensity) in the area on the +Y side of non-exposure lights NLₖ₋₁, NL₆, NL₁₁, NL₁₀, and NL₁, and furthermore can irradiate non-exposure lights NLₖ₊₁, NL₁, NLₘ, and NLₙ₋₁ at a fourth intensity (less than the third intensity) in the area on the +Y side of non-exposure lights NLₖ, NL₇, NL₈, NL₉, and NLₙ. As a consequence, for example, in projection optical system PL (and, as a result, in optical system PLL), an aberration (change) that gradually changes from one side to the other side within a surface orthogonal to the optical axis occurs, as is shown in FIG. 9B.

In this case, in order to correct the aberration (change) of projection optical system PL (and optical system PLL), main controller 50 drives at least one of the five movable lenses including lens 90 via image-forming characteristics correction controller 52 in a gradient direction (in this case, the θx direction) with respect to a plane orthogonal to optical axis AX1. According to this operation, the aberration (change) that has occurred in optical system PLL is corrected. This correction can be performed during exposure, as a matter of course, or it can also be performed during a non-exposure period, such as during the stepping movement of wafer stage WST (wafer W) between the exposure of a shot area on wafer W and the exposure of the following shot area or during wafer exchange.

In the embodiment, in order to generate a rotational symmetry in projection optical system PL (optical system PLL) or an aberration (change) that gradually changes from one side to the other side within a plane orthogonal to the optical axis as is described above (or in other words, to suppress the generation of the non-rotational symmetry aberration previously described), the relation between the target value of the intensity (and the total energy amount) of the non-exposure lights that irradiation mechanisms 95₁ to 95ₙ each should irradiate and the intensity (and the total energy amount) of illumination light IL that is irradiated on optical system PL is obtained based on the results by experiment or simulation. Therefore, main controller 50 monitors the intensity (and the total energy amount) of illumination light IL irradiated on optical system PL based on the detection values of integrator sensor 46 and reflection amount monitor 47, and according to this, main controller 50 controls the target values of the intensity (and the total energy amount) of the non-exposure lights of each of the irradiation mechanisms 95₁ to 95ₙ that are provided to control section 92B.

Incidentally, for example, a plurality of temperature sensors by the non-contact method can be arranged in the vicinity of lens 90, and the temperature distribution of lens 90 can be measured by the measurement values of each temperature sensor. In such a case, the target values of the intensity (and the total energy amount) of the non-exposure lights of each of the irradiation mechanisms 95₁ to 95ₙ can be decided based on the measurement results of the temperature distribution. Further, in the case the position, the shape, the size of illumination area IA' or the light quantity distribution within illumination area IA' changes, at least one of the position, the shape, the size, and the intensity of the irradiation area of the non-exposure lights of each of the irradiation mechanisms 95₁ to 95ₙ can be changed according to the change. For example, in the case of changing the position, the shape, and the size of illumination area IA' by moving the first reticle blind 30A, at least one of the position, the shape, the size of the irradiation area, and the intensity of the non-exposure lights that each of the irradiation mechanisms 95₁ to 95ₙ irradiates can be changed, based on the setting information of the first reticle blind 30A. Further, in the case the light quantity distribution of illumination area IA' changes due to the change of reticle R, at least one of the position, the shape, the size of the irradiation area, and the intensity of the non-exposure lights that each of the irradiation mechanisms 95₁ to 95ₙ irradiates can be adjusted according to the pattern information of reticle R.

Next, in exposure apparatus 100 of the embodiment, for example, the case is considered when the pattern on reticle R is projected on the wafer in a Fourier transform equivalent plane (the pupil plane of illumination optical system 12) of the pattern surface of reticle R, under an X-axis dipole illumination condition, in which a light quantity distribution which maximum values are formed at two positions eccentric by substantially the same distance from the optical axis of the illumination optical system (coincides with optical axis AX of the projection optical system) in a direction corresponding to the X-axis direction serving as the non-scanning direction. The X-axis dipole illumination condition is, for example, set in the case when the pattern subject to transfer is a line-and-space (L/S) pattern that has a predetermined period (hereinafter referred to as a V pattern) in the non-scanning direction.

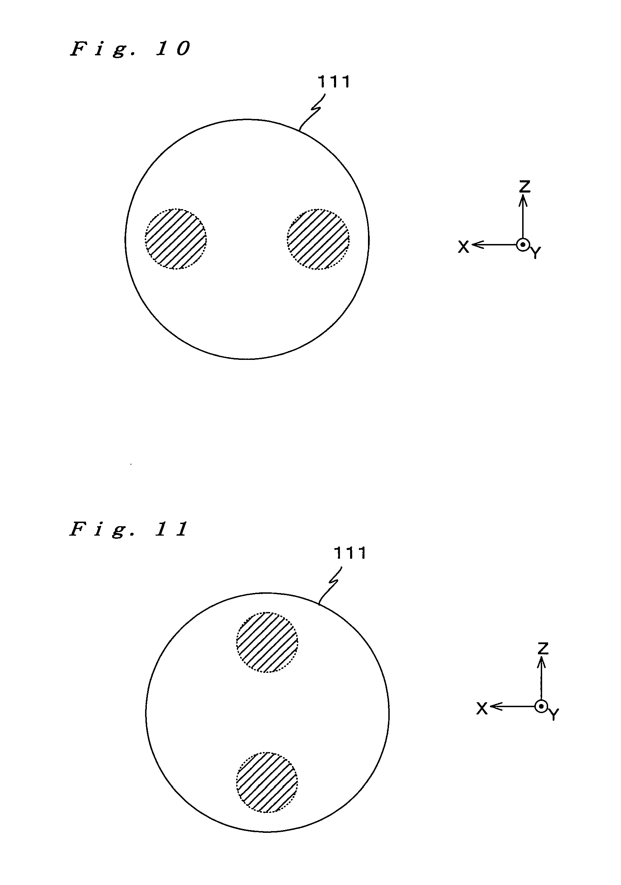

FIG. 10 shows an example of a light quantity distribution on a lens in the vicinity of the pupil planes (PP1, PP2, and PP3) of the projection optical system under the X-axis dipole illumination condition, such as for example, lens 111 previously described. In the drawing, the section marked with diagonal lines shows the irradiation area of illumination light IL.

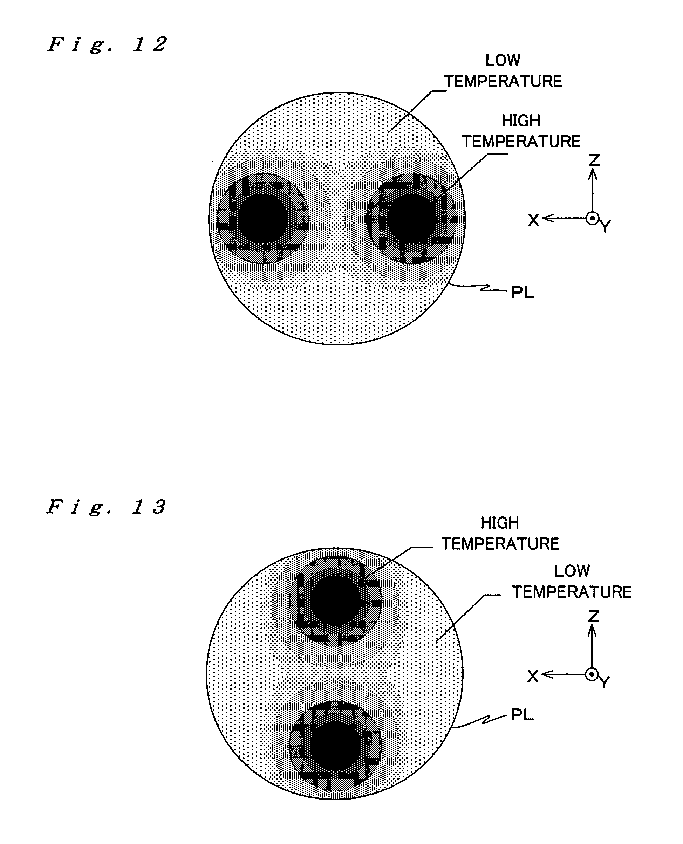

Under the X-axis dipole illumination condition, in (the vicinity of the pupil plane of) projection optical system PL, a non-rotational symmetry temperature distribution such as the one, for example, in FIG. 12, occurs by the absorption of the illumination light. Under the X-axis dipole illumination condition, focus anisotropy, which is a deviation of the image-forming plane (the best focus plane) of two kinds of L/S patterns that have orthogonal periodic directions occurs in the vicinity of the optical axis of projection optical system PL, or in other words, center astigmatism occurs. Under the X-axis dipole illumination condition, focus anisotropy occurs similarly in areas other than the vicinity of the optical axis of projection optical system PL.

Further, for example, the case is considered when the pattern on reticle R is projected on the wafer under a Y-axis dipole illumination condition, in which a light quantity distribution which maximum values are formed at two positions, which is eccentric by substantially the same distance from the optical axis (coincides with optical axis AX of the projection optical system) of illumination optical system 12 in a direction corresponding to the Y-axis direction serving as the scanning direction, on the pupil plane of illumination optical system 12. The Y-axis dipole illumination condition is, for example, set in the case when the pattern subject to transfer is a line-and-space (L/S) pattern that has a predetermined period (hereinafter referred to as an H pattern) in the scanning direction.

Under the Y-axis dipole illumination condition, on the lens in the vicinity of the pupil planes (PP1, PP2, and PP3) of the projection optical system, such as for example, lens 111 previously described, a light quantity distribution as is shown in FIG. 11 occurs. The section marked with diagonal lines in FIG. 11 shows the irradiation area of illumination light IL.

Under the Y-axis dipole illumination condition, in (the vicinity of the pupil plane of) projection optical system PL, a non-rotational symmetry temperature distribution such as the one, for example, in FIG. 13, occurs by the absorption of illumination light IL. Under the Y-axis dipole illumination condition, focus anisotropy (center astigmatism) occurs in which the best focus plane of the V pattern and the best focus plane of the H pattern are in an inversed relation to the X-axis dipole illumination condition.

In the embodiment, on the scanning exposure previously described, main controller 50 sets illumination conditions using illumination system aperture stop plate 24, according to the pattern subject to projection. In this case, main controller 50 computes the light quantity distribution of illumination light IL to lens 111 of projection optical system PL, and then based on the computed light quantity distribution of illumination light IL, main controller 50 predicts the uneven distribution state of heat that is generated in lens 111. Then, based on instructions from main controller 50 according to the prediction results, the control section of light source system 92' appropriately selects the irradiation mechanism from the eight irradiation mechanisms 95A₁ to 95A₈ and then irradiates non-exposure light NE (infrared light) from the selected irradiation mechanism on the side surface of lens 111.

As an example, in the case the X-axis dipole illumination condition is set as the illumination condition, and lens 111 is predicted to be in a heated state (temperature distribution) shown in FIG. 10, the control section irradiates non-exposure light NE from the irradiation mechanism excluding irradiation mechanisms 95A₄ and 95A₈, that is, irradiation mechanisms 95A₁, 95A₂, 95A₃, 95A₅, 95A₆, and 95A₇ on the side surface of lens 111 based on the instruction from main controller 50, so that the heated state of projection optical system PL is shaped into a rotational symmetry. In this case, the intensity of the infrared light irradiated from irradiation mechanisms 95A₂ and 95A₆ is to be stronger compared with the infrared light from the other irradiation mechanisms 95A₁, 95A₃, 95A₅, and 95A₇. As a consequence, anisotropic image-forming performance such as the center astigmatism generated in projection optical system PL (optical system PLL) is corrected, which generates rotational symmetry image-forming characteristics (change).

As is described, in the embodiment, because both the irradiation of non-exposure light NE from non-exposure light irradiation mechanism 91A for correcting the non-rotational symmetry temperature distribution on the pupil plane of projection optical system PL and the irradiation of non-exposure light NL from non-exposure light irradiation mechanism 91 for correcting the non-rotational symmetry temperature distribution occurring in lens 90 of projection optical system PL closest to the reticle are employed, which suppresses the generation of the non-rotational symmetry aberration (image-forming characteristics) change of projection optical system PL (optical system PLL) and generates the rotational symmetry aberration change of projection optical system PL (optical system PLL), as well as corrects the rotational symmetry aberration change of projection optical system PL (optical system PLL) via image-forming characteristics correction controller 52 previously described, pattern transfer of reticle R is performed in a favorable image-forming state.

Incidentally, for example, a plurality of temperature sensors by the non-contact or the contact method can also be arranged in the vicinity of lens 111, and the temperature distribution of lens 111 can be measured based on the measurement values of each temperature sensor. In such a case, at least one of the position, the shape, the size, and the intensity (and the total energy amount) of the non-exposure lights that each of the irradiation mechanisms 95A₁ to 95Aₙ is to irradiate can be adjusted, based on the measurement results of the temperature distribution.

Further, in an immersion exposure apparatus such as exposure apparatus 100 of the embodiment, the purity of the liquid (purified water) may deteriorate when the liquid is continuously used, and bacteria may possibly be generated. Therefore, in the embodiment, in order to prevent such a situation as much as possible, liquid Lq2 in the second space K2 is exchanged regularly. However, because the exchange of liquid Lq2 lowers the throughput, the exchange cannot be performed frequently. Thus, in the embodiment, main controller 50 exchanges liquid Lq2 in the second space K2 just before starting the exposure of the first wafer in each lot (or when exposure of a predetermined number of wafers has been completed) using the second liquid supply unit 72 and the second liquid recovery unit 73, and then begins exposure at the stage when the temperature of liquid Lq2 rises to substantially the same temperature as border lens 192 or the like such as when after a certain amount of time elapses. The reason for this is to keep the variation amount of the image-forming performance of optical system PLL due to the illumination light absorption by liquid Lq2 from changing drastically by the exchange of liquid Lq2, so as to prevent a large error from occurring in the estimated calculation of the irradiation variation of the image-forming characteristics of optical system PLL.

As is described above, according to exposure apparatus 100 of the embodiment, by the combination of optical properties adjustment of projection optical system PL (optical system PLL) by the irradiation of non-exposure light NL from non-exposure light irradiation mechanism 91 to lens 90, which can be moved, and optical properties adjustment of projection optical system PL (optical system PLL) by moving at least one movable lens by image-forming characteristics correction controller 52, it becomes possible to correct the variation in the optical properties due to the non-rotational symmetry temperature distribution of lens 90 with high precision.

Further, according to exposure apparatus 100 of the embodiment, for example, under the illumination condition in which the light quantity distribution of illumination light IL on the pupil plane of illumination optical system 12 or on the pupil plane of the projection optical system becomes non-rotational symmetry to the optical axis and the lens of projection optical system PL is locally (unevenly) heated by the irradiation of illumination light IL, by irradiating the non-exposure light (infrared light) on the remaining part of the lens where illumination light IL is not irradiated from non-exposure light irradiation mechanism 91 and by heating the lens in the manner described above, as a consequence, the temperature distribution of the lens can substantially have rotational symmetry. This can suppress non-rotational symmetry aberration such as the center astigmatism, which is difficult to correct, from occurring in projection optical system PL (optical system PLL) due to uneven temperature distribution in the lens. In other words, when the above heating of the lens is performed after the center astigmatism occurs, the center astigmatism will be corrected. Therefore, the center astigmatism occurring under the illumination condition in which the light quantity distribution on the pupil plane of projection optical system PL becomes non-rotational symmetry with respect to the optical axis, such as the dipole illumination, is corrected, and the pattern is transferred onto the wafer via projection optical system PL (optical system PLL) that has been corrected. Accordingly, the influence of the center astigmatism occurring in the projection optical system due to the illumination condition can be reduced, and exposure with high precision can be achieved.

Further, in the embodiment, because non-exposure light irradiation mechanism 91A is able to irradiate non-exposure light NE on the lens (dioptric element) constituting a part of projection optical system PL in which illumination light IL passes back and forth, or in other words, on lens 111, which can absorb more energy of illumination light IL that has been irradiated than an optical element in which illumination light IL passes through only once, the non-rotational symmetry image-forming characteristics (change) such as the center astigmatism of projection optical system PL (optical system PLL) by the irradiation of illumination light IL occurring under the illumination condition in which the light quantity distribution of illumination light IL on the pupil plane (PP1, PP2, and PP3) of projection optical system PL becomes non-rotational symmetry with respect to the optical axis can be effectively corrected.

Further, in exposure apparatus 100 of the embodiment, in order to adjust the optical properties of projection optical system PL (optical system PLL), of the three pupils of projection optical system PL, non-exposure light irradiation mechanism 91A irradiates non-exposure light NE on lens 111, which is positioned in the vicinity of the second pupil plane PP2. Accordingly, in the case projection optical system PL has a numerical aperture NA larger than one, an effective non-exposure light irradiation is possible compared with when the non-exposure light is irradiated on a lens in the vicinity of the third pupil plane PP3. The reason is because in the case of such a projection optical system with a large NA, the optical elements tend to become larger when closer to the image plane (wafer surface).

Further, in the embodiment, because an infrared ray irradiation mechanism is used as non-exposure light irradiation mechanisms 91 and 91A, heating of the lens can also be performed during exposure by non-exposure light irradiation mechanisms 91 and 91A. Accordingly, it becomes possible to suppress the generation of optical properties (for example, non-rotational symmetry aberration) that are difficult to correct in projection optical system PL (optical system PLL) without fail.

Further, the heating of the lens by the infrared ray is different from the heating by a contact type heating mechanism (heat source) or the cooling by a contact type cooling mechanism, and is performed in a noncontact manner, therefore, there is no risk of the lens being distorted due to contact by the heating mechanism or the cooling mechanism. Also, there is no risk of the lens vibrating, as in the case when cooling is performed by air distribution.

According to exposure apparatus 100 of the embodiment, exposure is of wafer W is performed favorably, and the pattern of reticle R is transferred with good precision on each shot area of wafer W. Further, in exposure apparatus 100 of the embodiment, by performing exposure with high resolution and with a larger depth of focus by the immersion exposure, the pattern of reticle R can be transferred with good precision on the wafer, and for example, the transfer of a fine pattern that has a device rule of around 45 to 100nm can be achieved, using the ArF excimer laser beam.

Further, in the embodiment, below border lens 192 that has a lens function, end optical element 191 consisting of a parallel plane plate is disposed, and by filling liquid Lq1 into the first space K1 under lower surface 191a of end optical element 191 and liquid Lq2 into the second space K2 above upper surface 191b of end optical element 191, reflection loss on lower surface 192a of boarder lens 192 and upper surface 191b of end optical element 191 is reduced which allows wafer W to be exposed favorably in a state where a large numerical aperture is secured on the image side. Further, because end optical element 191 is a parallel plane plate free of refractive power, end optical element 191 can be easily exchanged, for example, even in the case when contaminated matters in liquid Lq1 adhere on lower surface 191a of end optical element 191.

In the case exchange of end optical element 191 is not taken into consideration, end optical element 191 can be a lens that has refractive power.

In the embodiment above, from the viewpoint of suppressing distortion and vibration of the lens described above, the lens is heated with the infrared light, which is irradiated from non-exposure light irradiation mechanisms 91 and 91A. The present invention, however, is not limited to this, and in the case temperature adjustment (partial heating or cooling) of the lens can be performed as in the non-exposure light irradiation mechanisms described above, other temperature adjustment mechanisms (such as a heating mechanism or a cooling mechanism) can also be used. For example, heating by a heating mechanism that employs a contact method by combining a heat sink and a heat source, heating and/or cooling by a heating/cooling mechanism that employs the contact method using a Peltier element or the like, heating or cooling by ventilation of gas which temperature is controlled, or a combination of any of the methods described above can be employed.

In the embodiment above, the case has been described where the exposure apparatus has both non-exposure light irradiation mechanism 91 that irradiates non-exposure light NL on lens 90 where illumination light IL passes through, in an area eccentric from optical axis AX, and non-exposure light irradiation mechanism 91A that irradiates non-exposure light NE on lens 111 positioned in the vicinity of the pupil. The present invention, however, is not limited to this. For example, the apparatus may simply have non-exposure light irradiation mechanism 91, or a mechanism similar to non-exposure light irradiation mechanism 91 that can partially adjust the temperature of an optical element disposed on the object side or the image plane side of projection optical system PL, that is, lens 90 or its neighboring lenses, or border lens 192 or its neighboring lenses. Even in such a case, the non-rotational symmetry optical properties (change) of projection optical system PL (optical system PLL), which occur due to the non-rotational symmetry temperature change in lens 90, border lens 192, or the like, caused by illumination light IL passing through the area eccentric from the optical axis, can be converted into optical properties (change) that can be easily corrected by partially controlling the temperature of lens 90, border lens 192, or the neighboring lenses.

Further, the exposure apparatus may simply have non-exposure light irradiation mechanism 91A, or a mechanism similar to non-exposure light irradiation mechanism 91A that can partially adjust the temperature of an optical element disposed in the vicinity of the pupil of projection optical system PL, that is, lens 111 or its neighboring lenses. Even in such a case, the non-rotational symmetry optical properties (change) of projection optical system PL (optical system PLL), which occur due to the non-rotational symmetry temperature change in the lens near the pupil plane, caused by the setting of illumination conditions such as dipole illumination, can be converted into rotational symmetry optical properties (change) by partially controlling the temperature of lens 111 or its neighboring lenses.

In the embodiment above, non-exposure light irradiation mechanism 91A irradiates non-exposure light on the side surface of lens 111, however, the present invention is not limited to this, and instead of non-exposure light irradiation mechanism 91A, a mechanism that irradiates non-exposure light on the optical surface (at least one of the entering surface and the outgoing surface) of lens 111 similar to non-exposure light irradiation mechanism 91 can also be used.

In the embodiment above, the case has been described where the optical properties (change) of projection optical system PL (optical system PLL) are corrected by moving the movable lens in the optical axis direction or in the direction of inclination after the optical properties of projection optical system PL are converted into optical properties (change) that can be easily corrected. The present invention, however, is not limited to this, and the irradiation of non-exposure light on the lens by non-exposure light irradiation mechanism 91 and the movement of the movable lens can be performed in parallel.

Further, in the case of arranging non-exposure light irradiation mechanism 91A for converting the non-rotational symmetry temperature distribution occurring in the lens in the vicinity of the pupil plane due to the setting of illumination conditions such as dipole illumination into a rotational symmetry temperature distribution, or a mechanism equivalent to non-exposure light irradiation mechanism 91A that can partially adjust the temperature of the lens in the vicinity of the pupil plane, the mechanism does not necessarily have to be arranged in the vicinity of the second pupil PP2 within the second image-forming optical system G2, and the mechanism can also be arranged in the vicinity of the first pupil PP1 within the first image-forming optical system G1. Further, the mechanism may be arranged both in the vicinity of the first pupil PP1 and the second pupil PP2. The point is, especially in projection optical system PL whose numerical aperture NA is larger than one and has a plurality of pupils, among the plurality of pupils, the mechanism is preferably arranged in the vicinity of a pupil besides the pupil closest to wafer W.

In the embodiment above, the same purified water is supplied as liquids Lq1 and Lq2, however, the quality of the purified water supplied to the first space (liquid Lq1) and the quality of the purified water supplied to the second space (liquid Lq2) can differ. The quality of the purified water includes, for example, temperature uniformity, temperature stability, specific resistance value, TOC (Total Organic Carbon) value, and the like.

For example, the quality of the purified water supplied to the first space K1 close to the image plane of projection optical system PL may be higher than the quality of purified water supplied to the second space K2. Further, a different type of liquid may be supplied to the first space and the second space so that liquid Lq1 that fills the first space K1 and liquid Lq2 that fills the second space K2 are of a different kind. For example, the second space K2 can be filled with a predetermined liquid other than the purified water (such as fluorinated oil). Since oil is a liquid that has a low probability of bacteria growth, the degree of cleanliness in the second space K2 or in the passage where liquid Lq2 (fluorinated oil) flows can be maintained.

Further, both liquids Lq1 and Lq2 can be liquid other than water. For example, in the case the light source of illumination light IL is the F₂ laser beam, because the F₂ laser beam does not have any transmittance to water, liquid Lq1 and liquid Lq2 may be fluorinated fluid such as perfluoropolyether (PFPE) or fluorinated oil that can transmit the F₂ laser beam. In this case, on the section that comes into contact with liquid Lq1 and liquid Lq2, for example, lyophilic treatment is performed, by forming a thin film with a material containing fluorine that has a molecular structure of small polarity. Further, as liquids Lq1 and Lq2, besides the liquids above, it is also possible to use material that has high transmittance to illumination light IL, a refractive index as high as possible, and stability to projection optical system PL and the photoresist coated on the surface of wafer W (for example, cederwood oil). And, also in this case, the surface treatment is performed, depending on the polarity of liquid Lq1 and liquid Lq2.

In the embodiment described above, the case has been described where both spaces K1 and K2 on the entering side and the outgoing side of the optical element (end optical element 191) disposed closest to the image plane side of projection optical system PL are filled with liquids Lq1 and Lq2, respectively. However, the liquid can be filled only in space K1 on the outgoing side of the end optical element. In this case, the end optical element does not have to be a parallel plane plate but can be an optical element (such as a lens) that has a refracting power.

Further, in the embodiment described above, the case has been described where image-forming characteristics correction controller 52 corrects the rotational symmetry image-forming characteristics (aberration) in particular, by moving at least one optical element of projection optical system PL. However, instead of the moving mechanism of the optical element, or in combination with the moving mechanism, for example, a mechanism for adjusting the refracting power (such as gas pressure) between the optical elements of projection optical system PL or a mechanism for adjusting the wavelength characteristics (such as center wavelength) of illumination light IL can also be used. Furthermore, the optical element that is to be moved by image-forming characteristics correction controller 52 is not limited to a refractive optical element such as a lens, and it can be other elements, as in a refractive optical element such as, for example, a mirror or a concave mirror. Further, the adjustment of the image-forming characteristics by image-forming characteristics correction controller 52 is performed when the variation amount of the image-forming characteristics exceeds a predetermined range, regardless of the irradiation of non-exposure light (NL and NE) on the optical elements of projection optical system PL.

In the immersion exposure apparatus described above, a case may occur where the numerical aperture NA of the projection optical system is 0.9 to 1.3. In such a case where numerical aperture NA becomes large, a case may occur of the image-forming characteristics deteriorating due to the polarization effect of the random polarized light conventionally used as the exposure light (illumination light IL) ; therefore, polarization illumination is preferably used. In this case, linear polarization illumination should be performed in the longitudinal direction of the line pattern of the line-and-space mark on the mask (reticle), and from the pattern of the mask (reticle), a large amount of diffracted light that has an S polarization component (TE polarization component), or in other words, diffracted light whose polarization direction component is in line with the longitudinal direction of the line pattern, should be emitted. In the case the space between projection optical system PL and the resist coated on the surface of wafer W is filled with liquid, the transmittance on the surface of the resist of the diffracted light with the S polarization component (TE polarization component), which contributes to improving contrast, becomes high when compared with when the space between projection optical system PL and the resist coated on the surface of wafer W is filled with air (gas), which allows a high image-forming quality even in the case when numerical aperture NA exceeds 1.0. In addition, it is further effective when appropriately combining, for example, a phase shift mask and/or an oblique illumination method (especially, the dipole illumination method) or the like in line with the longitudinal direction of the line pattern as is disclosed in, Kokai (Japanese Unexamined Patent Application Publication) No. 6-188169, and Kokai (Japanese Unexamined Patent Application Publication) No. 4-180612 and the corresponding U.S. Patent No. 6,665,050 and the like.

Further, not only is the linear polarization illumination (S polarization illumination) in line with the longitudinal direction of the liner pattern of the mask (reticle) effective, but as is disclosed in Kokai (Japanese Unexamined Patent Application Publication) No. 6-53120, U.S. Patent Application Publication No. 2006/0072095 and the like, a combination of a polarization illumination method in which linear polarization is performed in a tangent (circumference) direction with the optical axis serving as the center and the oblique illumination method is also effective.

As projection optical system PL, a catadioptric system disclosed in, for example, the pamphlet of International Publication Number WO2004/019128, the pamphlet of International Publication Number WO2004/107011, U.S. Patent No. 6,636,350, U.S. Patent No. 6,873,476, or U.S. Patent Application Publication No. 2004/0160666 can be used.

In the case the projection optical system is a refracting system that does not include a reflection element, if the system has a lens in which the exposure light passing through an area eccentric from the optical axis passes, the system can employ non-exposure light irradiation mechanism 91 previously described or a mechanism that has the same function as non-exposure light irradiation mechanism 91 so as to correct the non-rotational symmetry temperature distribution that occurs in the lens.

Further, in the embodiment above, as the optical properties of optical system PLL, the irradiation variation is predicted not only for focus but is also predicted for magnification and distortion, and the optical properties adjusted. However, the prediction of the variation and the adjustment can be performed by selecting at least one of such optical properties if necessary.

In the embodiment above, the case has been described where each position information of reticle stage RST and wafer stage WST is measured using the interferometer system (53, 56). The present invention, however, is not limited to this, and for example, an encoder system that detects the scale (diffraction grating) arranged on each stage can be used. In this case, it is preferable for the system to be a hybrid system that is equipped with both the interferometer system and the encoder system, and that calibration of the measurement results of the encoder system is performed using the measurement results of the interferometer system. Further, the position of the stages can be controlled by switching between the interferometer system and the encoder system or, by using both the interferometer system and the encoder system.

In the embodiment above, the case has been described where the present invention is applied to a scanner (scanning exposure apparatus). However, the present invention is not limited to this, and the present invention can be applied to an exposure apparatus of a static exposure type such as the exposure apparatus by the step-and-repeat method (stepper), or to an exposure apparatus by the step-and-stitch method. Further, the present invention can be applied not only to an immersion exposure apparatus but also to an exposure apparatus that does not use the immersion method.

Further, the present invention can be applied to a multi-stage type exposure apparatus that has a plurality of wafer stages for holding the wafer like the ones disclosed in, Kokai (Japanese Unexamined Patent Application Publication) No. 10-163099, Kokai (Japanese Unexamined Patent Application Publication) No. 10-214783 and the corresponding U.S. Patent No. 6,341,007, Kohyo (Japanese Unexamined Patent Application Publication) No. 2000-505958 and the corresponding U.S. Patent No. 5,969,441, and the like. Further, as is disclosed in, for example, the pamphlet of International Publication Number WO2005/074014 or the like, the present invention can also be applied to an exposure apparatus that has a measurement stage separate from wafer stage WST.

Further, in the embodiment above, the exposure apparatus in which liquid is locally filled in the space between projection optical system PL and wafer W is employed, however, it is also possible to apply the present invention to an immersion exposure apparatus that performs exposure in a state where the entire surface of the wafer or the like which is subject to exposure is soaked in the liquid as in the ones disclosed in, Kokai (Japanese Unexamined Patent Application Publication) No. 6-124873, Kokai (Japanese Unexamined Patent Application Publication) No. 10-303114, U.S. Patent No. 5,825,043, and the like.

Further, in the embodiment above, a transmittance type mask was used, which is a transmissive substrate on which a predetermined light shielding pattern (or a phase pattern or a light-reducing pattern) was formed. Instead of this mask, however, as is disclosed in, for example, U.S. Patent No. 6,778,257, an electron mask (also called a variable shaped mask and includes, for example, a DMD (a Digital Micromirror Device), which is a type of a non-emitting image display device (spatial light modulator)) can also be used on which a light-transmitting pattern, a reflection pattern, or an emission pattern is formed according to electronic data of the pattern that is to be exposed.

Further, as is disclosed in the pamphlet of International Publication Number WO2001/035168, by forming interference fringes on wafer W, the present invention can also be applied to an exposure apparatus (lithography system) that forms line-and-space patterns on wafer W. Furthermore, as is disclosed in, for example, Kohyo (Japanese Unexamined Patent Application Publication) No. 2004-519850 (the corresponding U.S. Patent No. 6,611,316), the present invention can also be applied to an exposure apparatus that synthesizes patterns of two masks on a substrate via a projection optical system, and performs double exposure of a shot area on the substrate substantially at the same time in a single scanning exposure.

As long as the national laws in designated states (or elected states), to which this international application is applied, permit, the above disclosures of the Kokai Publications, the pamphlets of International Publications, the U.S. Patents and the U.S. Patent Application Publications description related to the exposure apparatus or the like referred to in the embodiment above are incorporated herein by reference.

The present invention is not limited to the exposure apparatus for manufacturing semiconductors, and it can also be widely applied to for example, an exposure apparatus used for manufacturing liquid crystal displays that transfers a liquid crystal display device pattern onto a glass plate which is rectangular in shape, an exposure apparatus used for manufacturing organic ELs, thin film magnetic heads, imaging devices (such as CCDs), micromachines, MEMS (Micro Electro Mechanical Systems), DNA chips, and the like. Further, the present invention can also be applied to an exposure apparatus that transfers a circuit pattern onto a glass substrate or a silicon wafer not only when producing microdevices such as semiconductors, but also when producing a reticle or a mask used in exposure apparatus such as an optical exposure apparatus, an EUV exposure apparatus, an X-ray exposure apparatus, and an electron beam exposure apparatus.

The light source of the exposure apparatus in the embodiment above is not limited to the ArF excimer laser, and it is also possible to use a pulsed laser light source such as the KrF excimer laser (output wavelength 248 nm), the F₂ laser (output wavelength 157 nm), the Ar₂ laser (output wavelength 126 nm), the Kr₂ laser (output wavelength 146 nm), or the like, or an ultra high-pressure mercury lamp that emits bright lines such as the g-line (wavelength 436 nm) or the i-line (wavelength 365 nm). Further, a harmonic generation unit of the YAG laser can also be used. Besides such units, as is disclosed in, for example, the pamphlet of International Publication Number WO1999/4683 a harmonic may also be used that is obtained by amplifying a single-wavelength laser beam in the infrared or visible range emitted by a DFB semiconductor laser or fiber laser, with a fiber amplifier doped with, for example, erbium (or both erbium and ytteribium), and by converting the wavelength into ultraviolet light using a nonlinear optical crystal. Further, the projection optical system is not limited to a reduction system, and the system may also be a system of equal magnification or a magnifying system.

The exposure apparatus in the embodiment above can be made by incorporating the illumination optical system made up of a plurality of lenses and the projection optical system into the main body of the exposure apparatus, performing the optical adjustment operation, and also attaching the reticle stage and the wafer stage made up of multiple mechanical parts to the main body of the exposure apparatus, connecting the wiring and piping, and then, further performing total adjustment (such as electrical adjustment and operation check). The exposure apparatus is preferably built in a clean room where conditions such as the temperature and the degree of cleanliness are controlled.

### Device Manufacturing Method

Next, an embodiment will be described of a device manufacturing method that uses the above exposure apparatus in the lithography step.

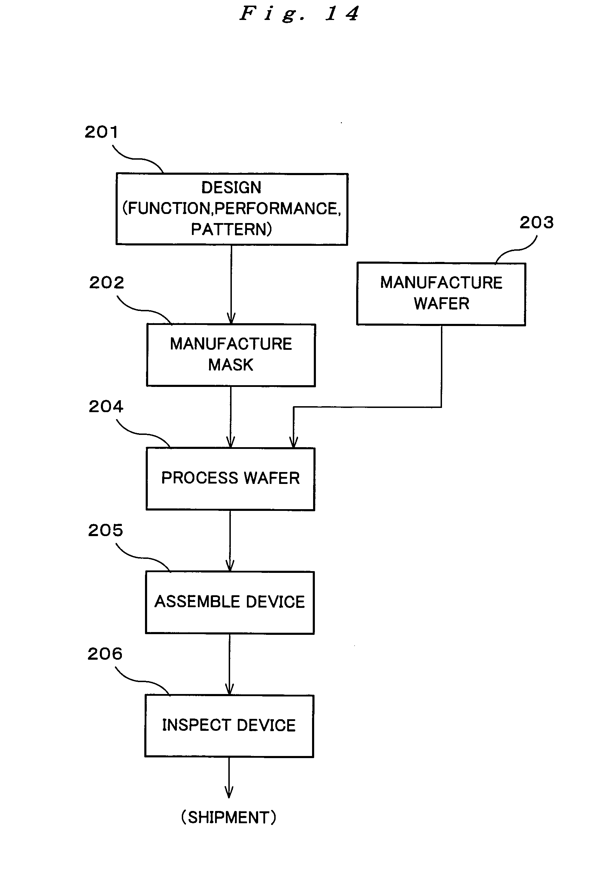

FIG. 14 shows the flowchart of an example when manufacturing a device (a semiconductor chip such as an IC or an LSI, a liquid crystal panel, a CCD, a thin-film magnetic head, a micromachine, and the like). As shown in FIG. 14, in step 201 (design step), function and performance design of device (circuit design of semiconductor device, for example) is performed first, and pattern design to realize the function is performed. Then, in step 202 (mask manufacturing step), a mask on which the designed circuit pattern is formed is manufactured. Meanwhile, in step 203 (wafer manufacturing step), a wafer is manufactured using materials such as silicon.

Next, in step 204 (wafer processing step), the actual circuit and the like are formed on the wafer by lithography or the like in a manner that will be described later, using the mask and the wafer prepared in steps 201 to 203. Then, in step 205 (device assembly step), device assembly is performed using the wafer processed in step 204. Step 205 includes processes such as the dicing process, the bonding process, and the packaging process (chip encapsulation), and the like when necessary.

Finally, in step 206 (inspection step), tests on operation, durability, and the like are performed on the devices made in step 205. After these steps, the devices are completed and shipped out.

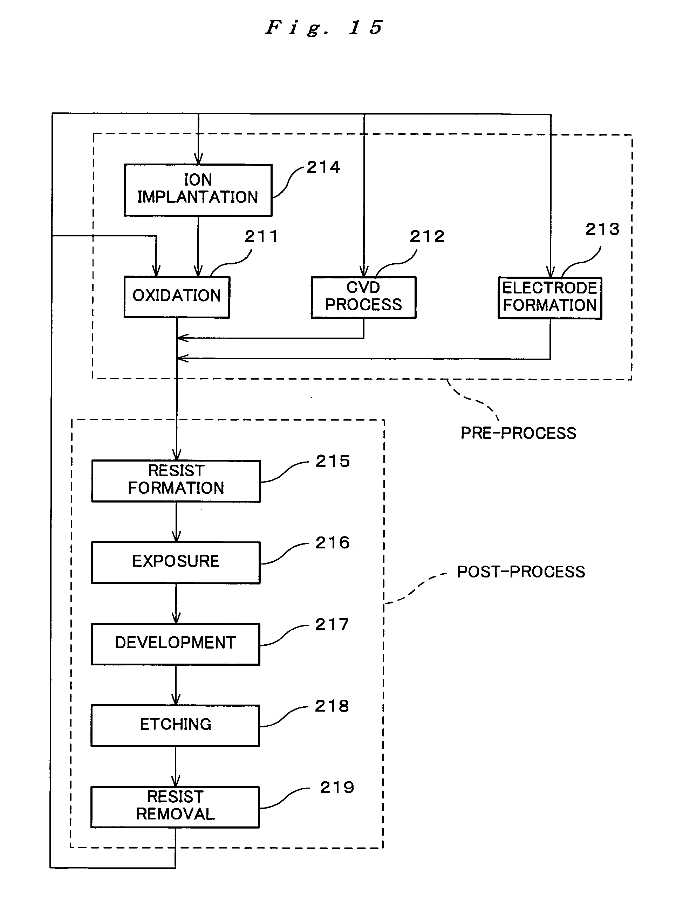

FIG. 15 is a flow chart showing a detailed example of step 204 described above related to semiconductor devices. Referring to FIG. 15, in step 211 (oxidation step), the surface of wafer is oxidized. In step 212 (CDV step), an insulating film is formed on the wafer surface. In step 213 (electrode formation step), an electrode is formed on the wafer by deposition. In step 214 (ion implantation step), ions are implanted into the wafer. Each of the above steps 211 to 214 constitutes the pre-process in each step of wafer processing, and the necessary processing is chosen and is executed at each stage.

When the above-described pre-process ends in each stage of wafer processing, post-process is executed as follows. In the post-process, first in step 215 (resist formation step), a photosensitive agent is coated on the wafer. Then, in step 216 (exposure step), the circuit pattern of the mask is transferred onto the wafer by the lithography system (exposure apparatus) and the exposure method of the embodiment above. Next, in step 217 (development step), the exposed wafer is developed, and in step 218 (etching step), an exposed member of an area other than the area where resist remains is removed by etching. Then, in step 219 (resist removing step), when etching is completed, the resist that is no longer necessary is removed.

By repeatedly performing the pre-process and the post-process, multiple circuit patterns are formed on the wafer.

According to the device manufacturing method in the embodiment described above, in the exposure process (step 216), the circuit pattern of the reticle is transferred with good precision by the exposure apparatus and the exposure method of the embodiment above. As a consequence, the productivity (including the yield) of high integration microdevices can be improved.

As is described above, the exposure method and the exposure apparatus of the present invention are suitable for exposing objects. Further, the device manufacturing method of the present invention is suitable for manufacturing microdevices.

## Claims

1. An exposure method in which an object is exposed with a first energy beam via an optical system and a predetermined pattern is formed on the object, the method comprising:
an irradiation process in which a second energy beam having a wavelength range different from the first energy beam is irradiated on at least one movable optical element constituting at least a part of the optical system so as to adjust optical properties of the optical system; and
a correction process in which optical properties of the optical system is adjusted by moving at least one movable optical element including the one movable optical element on which the second energy beam is irradiated.

2. The exposure method of Claim 1 wherein
as the optical system, an optical system is used in which the first energy beam pass through an area eccentric from the optical axis at a plurality of points that include an end section on the object side and an end section on the opposite side.

3. The exposure method of Claim 2 wherein
the optical system is a catadioptric system that contains at least one dioptric element and at least one catoptric element.

4. The exposure method of Claim 2 wherein
in the irradiation process, of at least one optical element located in the vicinity of the end section on the object side of the optical system and at least one optical element located in the vicinity of the end section on the opposite side, the second energy beam is irradiated on at least one of the optical element that is movable.

5. The exposure method of Claim 1 wherein
in the irradiation process, the second energy beam is irradiated on the optical element so as to generate rotational symmetry optical properties in the optical system, and
in the correction process, the rotational symmetry optical properties in the optical system is adjusted by moving the at least one movable optical element.

6. The exposure method of Claim 5 wherein
in the correction process, the at least one movable optical element is moved in a direction in the optical axis of the optical system.

7. The exposure method of Claim 1 wherein
in the irradiation process, the second energy beam is irradiated on the optical element so as to generate optical properties that gradually change from one side to the other side within a plane perpendicular to the optical axis of the optical system, and
in the correction process, the optical properties of the optical system that change from one side to the other side is adjusted by moving the at least one movable optical element.

8. The exposure method of Claim 7 wherein
in the correction process, the at least one movable optical element is moved in a gradient direction with respect to the plane perpendicular to the optical axis of the optical system.

9. In the case energy intensity of the first energy beam at a position eccentric from the optical axis on a pupil plane of the optical system is larger than other areas, the exposure method of Claim 1 further comprises:
an irradiation process in which a third energy beam is irradiated so as to make a rotational symmetry distribution of the energy intensity on the pupil plane.

10. The exposure method in Claim 1 wherein
the second energy beam is an infrared light.

11. The exposure method of Claim 10 wherein
the second energy beam is a carbon dioxide laser beam.

12. The exposure method of Claim 1 wherein
the optical system contains at least one optical element different from a predetermined optical element on which the second energy beam is irradiated, and
the second energy beam is irradiated on the predetermined optical element without the second energy beam going through an optical element different from the optical element on which the second energy beam is irradiated.

13. An exposure method in which an object is exposed with an energy beam via an optical system and a predetermined pattern is formed on the object, the method using
a catadioptric system in which an energy beam passes through an area eccentric to the optical axis at a plurality of points including an end section on the object side and an end section on the opposite side as the optical system, the system containing at least one dioptric element and at least one catoptric element, wherein the method comprises
an adjustment process in which in a plurality of optical elements of the optical system, optical properties of the optical system is adjusted by performing at least temperature adjustment of a predetermined optical element in which the energy beam passes at a position eccentric to the optical axis so as to make the predetermined optical element have a concentric temperature distribution around the optical axis.

14. The exposure method of Claim 13 wherein
the predetermined optical element is movable so as to adjust the optical properties of the optical system.

15. The exposure method of Claim 13 wherein
temperature adjustment of the predetermined optical element is performed by irradiating another energy beam whose wavelength is different from the energy beam on the predetermined optical element.

16. The exposure method of Claim 15 wherein
the another energy beam is an infrared light.

17. The exposure method of Claim 16 wherein
the another beam is a carbon dioxide laser beam.

18. The exposure method of Claim 15 wherein
the optical system contains at least one optical element different from a predetermined optical element on which the another energy beam is irradiated, and
the another energy beam is irradiated on the predetermined optical element without the another beam going through an optical element different from the optical element on which the another beam is irradiated.

19. An exposure method in which an object is exposed with an energy beam via an optical system and a predetermined pattern is formed on the object, the method using
a catadioptric system in which the energy beam passes through an area eccentric to the optical axis at a plurality of points including an end section on the object side and an end section on the opposite side as the optical system, the system containing at least one dioptric element and at least one catoptric element, wherein the method comprises
an adjustment process in which in a plurality of optical elements of the optical system, optical properties of the optical system is adjusted by performing at least temperature adjustment of a predetermined optical element in which the energy beam passes at a position eccentric to the optical axis so as to make the predetermined optical element have a temperature distribution that gradually changes from one side to the other side within a plane orthogonal to the optical axis.

20. The exposure method of Claim 19 wherein
the predetermined optical element is movable so as to adjust the optical properties of the optical system.

21. The exposure method of Claim 19 wherein
temperature adjustment of the predetermined optical element is performed by irradiating a different energy beam whose wavelength differs from the energy beam on the predetermined optical element.

22. The exposure method of Claim 21 wherein
the different energy beam is an infrared light.

23. The exposure method of Claim 22 wherein
the different energy beam is a carbon dioxide laser beam.

24. The exposure method of Claim 21 wherein
the optical system contains at least one optical element different from a predetermined optical element on which the different energy beam is irradiated, and
the different energy beam is irradiated on the predetermined optical element without the different energy beam going through an optical element different from the optical element on which the different energy beam is irradiated.

25. An exposure method in which an object is exposed with a first energy beam via an optical system and a predetermined pattern is formed on the obj ect, the method using
a catadioptric system which contains at least one dioptric element and at least one catoptric element as the optical system, wherein the method comprises
an irradiation process in which a second energy beam having a wavelength range different from the first energy beam is irradiated on a dioptric element configuring a part of the optical system where the first energy beam passes back and forth, so as to adjust optical properties of the optical system.

26. The exposure method of Claim 25 wherein
the dioptric element on which the second energy beam is irradiated is disposed in the vicinity of a pupil within the optical system.

27. The exposure method of Claim 25 wherein
the first energy beam is reflected by the catoptric element via a dioptric system on which the second energy beam is irradiated within the optical system, and enters the dioptric element again.

28. The exposure method of Claim 25 wherein
in the irradiation process where the second energy beam is irradiated, the second energy beam is irradiated on the side surface of the optical element.

29. The exposure method of Claim 25 wherein
the second energy beam is an infrared light.

30. The exposure method of Claim 29 wherein
the second energy beam is a carbon dioxide laser beam.

31. The exposure method of Claim 25 wherein
the optical system contains at least one optical element different from a predetermined optical element on which the second energy beam is irradiated, and
the second energy beam is irradiated on the predetermined optical element without the second energy beam going through an optical element different from the optical element on which the second energy beam is irradiated.

32. An exposure method in which an object is exposed with a first energy beam via an optical system and a predetermined pattern is formed on the object, the method using
a catadioptric system which contains at least one dioptric element and at least one catoptric element and has a plurality of pupils that are optically conjugate as the optical system, wherein the method comprises
an irradiation process in which a second energy beam having a wavelength range different from the first energy beam is irradiated on an optical element located in the vicinity of a pupil besides the pupil closest to the object of the plurality of pupils, so as to adjust the optical properties of the optical system.

33. The exposure method of Claim 32 wherein
an aperture stop is arranged at the position of at least one pupil among the plurality of pupils, the stop setting the numerical aperture of the optical system.

34. The exposure method of Claim 32 wherein
in the irradiation process where the second energy beam is irradiated, the second energy beam is irradiated on the side surface of the optical element.

35. The exposure method of Claim 32 wherein
the second energy beam is an infrared light.

36. The exposure method of Claim 35 wherein
the second energy beam is a carbon dioxide laser beam.

37. The exposure method of Claim 32 wherein
the optical system contains at least one optical element different from a predetermined optical element on which the second energy beam is irradiated, and
the second energy beam is irradiated on the predetermined optical element without the second energy beam going through an optical element different from the optical element on which the second energy beam is irradiated.

38. A device manufacturing method that includes a lithography process in which a pattern of a device is formed on an object using the exposure method of any one of Claims 1 to 37.

39. An exposure apparatus that exposes an object with a first energy beam and forms a predetermined pattern on the object, the apparatus comprising:
an optical system that comprises at least one movable optical element and emits the first energy beam on the object;
an irradiation unit that irradiates a second energy beam having a wavelength range different from the first energy beam on the at least one movable optical element so as to adjust the optical properties of the optical system; and
an optical properties adjustment unit that adjusts the optical properties of the optical system by moving at least one movable optical element including the movable optical element on which the second energy beam is irradiated.

40. The exposure apparatus of Claim 39 wherein
the optical system is an optical system in which the first energy beam passes an area eccentric from the optical axis at a plurality of points including an end section on the object side and an end section on the opposite side.

41. The exposure apparatus of Claim 40 wherein
the optical system is a catadioptric system that contains at least one dioptric element and at least one catoptric element.

42. The exposure apparatus of Claim 39 wherein
the irradiation unit irradiates the second energy beam on the optical element so as to generate rotational symmetry optical properties in the optical system, and
the optical properties adjustment unit adjusts the rotational symmetry optical properties in the optical system by moving the at least one movable optical element.

43. The exposure apparatus of Claim 42 wherein
the optical properties adjustment unit moves the at least one movable optical element in a direction in the optical axis of the optical system.

44. The exposure apparatus of Claim 39 wherein
the irradiation unit irradiates the second energy beam on the optical element so as to generate optical properties that gradually change from one side to the other side within a plane perpendicular to the optical axis of the optical system, and
the optical properties adjustment unit adjusts the optical properties of the optical system that change from one side to the other side by moving the at least one movable optical element.

45. The exposure apparatus of Claim 44 wherein
the optical properties adjustment unit moves the at least one movable optical element in a gradient direction with respect to the plane perpendicular to the optical axis of the optical system.

46. The exposure apparatus of Claim 39 wherein
of at least one optical element located in the vicinity of the end section on the object side of the optical system and at least one optical element located in the vicinity of the end section on the opposite side, the irradiation unit irradiates the second energy beam on at least one of the optical element that is movable.

47. The exposure apparatus of Claim 39 wherein
in the case energy intensity of the first energy beam at a position eccentric from the optical axis on a pupil plane of the optical system is larger than other areas, the apparatus further comprising:
an irradiation unit different from the irradiation unit that irradiates a third beam on an optical element in the vicinity of the pupil plane so as to make a rotational symmetry distribution of the energy intensity on the pupil plane.

48. The exposure apparatus of Claim 39 wherein
the second energy beam is an infrared light.

49. The exposure apparatus of Claim 48 wherein
the second energy beam is a carbon dioxide laser beam.

50. The exposure apparatus of Claim 39 wherein
the optical system contains at least one optical element different from a predetermined optical element on which the second energy beam is irradiated, and
the second energy beam is irradiated on the predetermined optical element without the second energy beam going through an optical element different from the optical element on which the second energy beam is irradiated.

51. An exposure apparatus that exposes an object with an energy beam and forms a predetermined pattern on the object, the apparatus comprising:
an optical system composed of a catadioptric system in which the energy beam passes through an area eccentric to the optical axis at a plurality of points including an end section on the object side and an end section on the opposite side, the system containing at least one dioptric element and at least one catoptric element; and
an optical properties adjustment unit that adjusts the optical properties of the optical system by performing at least temperature adjustment of a predetermined optical element in which the energy beam passes at a position eccentric to the optical axis among a plurality of optical elements in the optical system so as to make the predetermined optical element have a concentric temperature distribution around the optical axis.

52. The exposure apparatus of Claim 51 wherein
the predetermined optical element is movable so as to adjust the optical properties of the optical system.

53. The exposure apparatus of Claim 51 wherein
the optical properties adjustment unit performs temperature adjustment of the predetermined optical element by irradiating a different energy beam whose wavelength differs from the first energy beam on the predetermined optical element.

54. The exposure apparatus of Claim 53 wherein
the different energy beam is an infrared light.

55. The exposure apparatus of Claim 54 wherein
the different energy beam is a carbon dioxide laser beam.

56. The exposure apparatus of Claim 53 wherein
the optical system contains at least one optical element different from a predetermined optical element on which the different energy beam is irradiated, and
the different energy beam is irradiated on the predetermined optical element without the different energy beam going through an optical element different from the optical element on which the different energy beam is irradiated.

57. An exposure apparatus that exposes an object with an energy beam and forms a predetermined pattern on the object, the apparatus comprising:
an optical system composed of a catadioptric system in which the energy beam passes through an area eccentric to the optical axis at a plurality of points including an end section on the object side and an end section on the opposite side, the system containing at least one dioptric element and at least one catoptric element; and an optical properties adjustment unit that adjusts optical properties of the optical system by performing at least temperature adjustment of a predetermined optical element in which the energy beam passes at a position eccentric to the optical axis among a plurality of optical elements in the optical system so as to make the predetermined optical element have a temperature distribution that gradually changes from one side to the other side within a plane orthogonal to the optical axis.

58. The exposure apparatus of Claim 57 wherein
the predetermined optical element is movable so as to adjust the optical properties of the optical system.

59. The exposure apparatus of Claim 57 wherein
the optical properties adjustment unit performs temperature adjustment of the predetermined optical element by irradiating a different energy beam whose wavelength differs from the energy beam on the predetermined optical element.

60. The exposure apparatus of Claim 59 wherein
the different energy beam is an infrared light.

61. The exposure apparatus of Claim 60 wherein
the different energy beam is a carbon dioxide laser beam.

62. The exposure apparatus of Claim 59 wherein
the optical system contains at least one optical element different from a predetermined optical element on which the different energy beam is irradiated, and
the different energy beam is irradiated on the predetermined optical element without the different energy beam going through an optical element different from the optical element on which the different energy beam is irradiated.

63. An exposure apparatus that exposes an object with a first energy beam and forms a predetermined pattern on the object, the apparatus comprising:
an optical system composed of a catadioptric system that emits the first energy beam on the object, the system containing at least one dioptric element and at least one catoptric element; and
an irradiation unit that irradiates a second energy beam having a wavelength range different from the first energy beam on a dioptric element configuring a part of the optical system where the first energy beam passes back and forth, so as to adjust optical properties of the optical system.

64. The exposure apparatus of Claim 63 wherein
the dioptric element on which the second energy beam is irradiated is disposed in the vicinity of a pupil within the optical system.

65. The exposure apparatus of Claim 63 wherein
the first energy beam is reflected by the dioptric element via a catoptric system on which the second energy beam is irradiated within the optical system, and enters the dioptric element again.

66. The exposure apparatus of Claim 63 wherein
the irradiation unit irradiates the second energy beam on the side surface of the optical element.

67. The exposure apparatus of Claim 63 wherein
the second energy beam is an infrared light.

68. The exposure apparatus of Claim 67 wherein
the second energy beam is a carbon dioxide laser beam.

69. The exposure apparatus of Claim 63 wherein
the optical system contains at least one optical element different from a predetermined optical element on which the second energy beam is irradiated, and
the second energy beam is irradiated on the predetermined optical element without the second energy beam going through an optical element different from the optical element on which the second energy beam is irradiated.

70. An exposure apparatus that exposes an object with a first energy beam and forms a predetermined pattern on the object, the apparatus comprising:
an optical system that emits the first energy beam on the object, the system containing at least one dioptric element and at least one catoptric element and has a plurality of pupils that are optically conjugate; and
an irradiation unit that irradiates a second energy beam having a wavelength range different from the first energy beam on an optical element, located in the vicinity of a pupil besides the pupil closest to the object of the plurality of pupils, so as to adjust the optical properties of the optical system.

71. The exposure apparatus of Claim 70, the apparatus further comprising:
an aperture stop arranged at the position of at least one pupil among the plurality of pupils, the stop setting the numerical aperture of the optical system.

72. The exposure apparatus of Claim 70 wherein
the irradiation unit irradiates the second energy beam on the side surface of the optical element.

73. The exposure apparatus of Claim 70 wherein
the second energy beam is an infrared light.

74. The exposure apparatus of Claim 73 wherein
the second energy beam is a carbon dioxide laser beam.

75. The exposure apparatus of Claim 70 wherein
the optical system contains at least one optical element different from a predetermined optical element on which the second energy beam is irradiated, and
the second energy beam is irradiated on the predetermined optical element without the second energy beam going through an optical element different from the optical element on which the second energy beam is irradiated.

76. A device manufacturing method that includes a lithography process in which a pattern of a device is formed on an object using the exposure apparatus of any one of Claims 39 to 75.
